# EUROPEAN PATENT SPECIFICATION

(11) **EP 0 735 565 B1**
(45) Date of publication and mention of the grant of the patent: **02.06.1999**
(21) Application number: 95480031.4
(22) Date of filing: 31.03.1995
(51) Int. Cl.: H01J 37/32

(54) **Method and apparatus for monitoring the dry etching of a dielectric film to a given thickness**
Verfahren und Gerät zur Überwachung des Trockenätzens eines dielektrischen Films bis zu einer gegebenen Dicke
Méthode et appareil pour contrôler la gravure sèche d'un film diélectrique jusqu'à une épaisseur donnée

(43) Date of publication of application: 02.10.1996
(73) Proprietor: International Business Machines Corporation, Armonk, N.Y. 10504 (US); SOFIE INSTRUMENTS, F-91290 Arpajon (FR)
(72) Inventor: Canteloup, Jean, F-91310 Montlhery (FR); Coronel, Philippe, F-91300 Massy (FR); Auda, Bernard, 91310 Montlhery (FR)
(74) Representative: Klein, Daniel Jacques Henri

(56) References cited:
- EP-A- 0 511 448
- WO-A-94/25977
- JOURNAL OF VACUUM SCIENCE AND TECHNOLOGY: PART B, vol. 10, no. 6, 1 November 1992 pages 2412-2418, XP 000331696 HAVERLAG M ET AL 'IN SITU ELLIPSOMETRY AND REFLECTOMETRY DURING ETCHING OF PATTERNED SURFACES: EXPERIMENTS AND SIMULATIONS'
- IBM TECHNICAL DISCLOSURE BULLETIN, vol. 34, no. 10B, 1 March 1992 pages 275-277, XP 000302716 'METHOD FOR OPTICAL INTERFERENCE MEASUREMENT AND CONTROL OF ETCHING'

## Description

The present invention relates to the manufacture of semiconductor integrated circuits and more particularly to a method and apparatus for monitoring the dry etching of a dielectric film or layer formed onto a substrate down to a given thickness or STOP THICKNESS.

### BACKGROUND OF THE INVENTION

In the manufacture of semiconductor integrated circuits (ICs), dry etching techniques, including plasma reactive ion etching (RIE), are extensively used for the removal or the patterning of layers of various materials and in particular of layers of a dielectric material formed onto the surface of a substrate. During the removal of such layers, the determination of the etch end point to stop etching at a given thickness is of paramount importance for process parameter control and finally the characteristics and performance of the resulting ICs. As a matter of fact, it is essential that the remaining thickness of a dielectric layer be equal or very close to the nominal value established in the product specifications. In addition, this remaining thickness must have a constant value from wafer to wafer in a same lot of wafers or even belonging to different lots of wafers. Obtaining such a pre-determined thickness with great reproducibility is a key factor for the successful completion of processing steps to which the wafers are subsequently submitted.

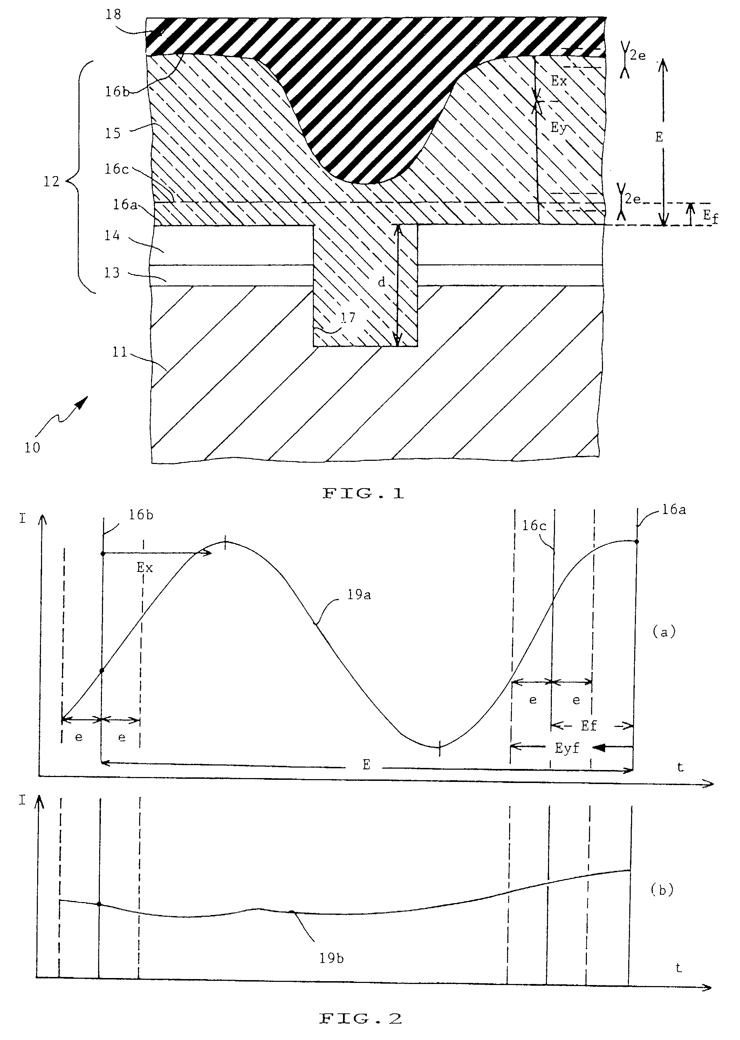

Fig. 1 schematically illustrates a part of a wafer which consists of a semiconductor structure 10 essentially comprised of a silicon body 11 and a stack 12 formed thereon by a plurality of insulating layers. Typically, the stack 12 consists of a bottom 30 nm thick SiO2 layer 13, an intermediate 150 nm thick Si3N4 layer 14 and an overlying SiO2 layer 15. The interface between the bottom of SiO2 layer 15 and the top of Si3N4 layer 14 is labelled 16a. The top of the SiO2 layer 15 is referenced 16b. SiO2 layer 15 is generally formed by LPCVD (Low Pressure Chemical Vapor Deposition)/PECVD (Plasma Enhanced Chemical Vapor Deposition) techniques SiO2 using tetra ethyl ortho silicate (TEOS) and oxygen. Body 11 is provided with a shallow isolation trench referenced 17. As such, structure 10 is a typical example of a silicon wafer after isolation trench formation used in the fabrication of 16 Mbits DRAM chips. At this stage of the fabrication, the structure 10 must be planarized and the initial thickness E of the SiO2 layer 15 must be reduced to a given value determined Ef by the product specifications. To that end, the structure 10 is coated with a layer 18 of a planarizing medium, such as a photo-resist, having broadly the same etching rate that the SiO2 material, and the structure 10 is etched back in a conventional dry etching tool. This etch back is generally completed in two processing steps, each step having its own gas chemistry. During the first step of the etch back process, the structure 10 is etched until the top of the SiO2 layer 15 is exposed. In the second step which uses a more reactive gas chemistry for greater aggressiveness, the SiO2 layer 15 is etched from surface 16b to a depth equal to Exf = E - Ef. The planar top surface of the remaining SiO2 layer 15 after etching is referenced 16c.

Fig. 1 illustrates a typical structure that is manufactured in a real manufacturing environment. However, the most general case would consist of a substrate (comprised of silicon body 11 with SiO2 layer 13 and Si3N4 layer 14 formed thereon in this case) coated with a dielectric layer (SiO2 layer 15). It is only required to have two different optical medium at their interface (16a) to allow interferometric measurements. The problem being to etch the dielectric layer down to a given thickness in a dry etching tool.

This etch back process may be monitored in its totality using the well known time thickness control technique which is based on the assumption that the etch rate of the SiO2 layer 15 is constant and can be determined prior the etch back step of the wafer takes place. The etch rate value is determined either from the teachings obtained from the processing of a previous lot on the same tool or alternatively by processing a sample wafer of the lot in consideration in the tool and then determining the etch rate value from this experiment. The latter variant is more accurate but is time consuming and may lead to the waste of an expensive wafer for each lot, in case of over-etching, which is not acceptable in a manufacturing environment. According to the time monitoring technique, the etching process is thus stopped as soon as the time corresponding to the determined final etched thickness Exf is attained. The real thickness Eyf of the remaining SiO2 layer 15 is finally measured according to standard spectroscopic interferometry techniques and compared to the desired final thickness Ef. If it is discovered that the SiO2 layer 15 has been overetched, the wafer must be rejected, because no adjustment is then possible. If the real thickness Eyf is above the desired final thickness value Ef, the wafer is submitted again to a new etching step in order to come closer to the said desired thickness value Ef, but in this case, an additional etch back is then required and the measurements attached thereto as well.

Another well known monitoring technique is based on interferometry. Interferometry allows in- situ and on line control of the current etched thickness Ex (the current thickness of the remaining SiO2 layer 15 is referenced Ey such as Ey = E - Ex) in real time under certain conditions. During the etch back process mentioned above, as soon as the top of the SiO2 layer 15 is exposed, the etch rate and the current etched thickness Ex can be continuously and accurately monitored. According to the standard technique, a monochromatic radiation emitted by a laser impinges the wafer incorporating the structure 10 at a normal angle of incidence. Interference fringes are formed by the radiations refracted from the top of SiO2 layer 15 and at the interface 16a formed between SiO2 layer 15 and the underlying layer 14 of Si3N4. An adequate detector, generally a photo-diode is illuminated by the reflected radiations and generates a signal whose intensity varies with the thickness of SiO2 layer 15 being etched. An improvement of this technique is described in EP-A-0511448 assigned to IBM Corp. According to that reference, the laser is no longer necessary, a determined radiation emitted by the plasma, in the instant case, the SiBr line is observed through a top view port by a spectrometer operating as an interferometer and through a side view port by another spectrometer. The signals generated by these spectrometers are processed in a digital computer according the claimed method described therein. This technique requires to have one radiation of sufficient intensity for being observed. The etching process stops when Ex = Exf, the thickness of the remaining SiO2 layer is thus given by Eyf = E - Exf. The real thickness Eyf of the remaining SiO2 layer cannot be measured on-line and in-situ with this technique, but needs to be performed outside the dry etching tool. In addition, the plasma is a very unstable medium whose parameters are only determined by process requirements (and thus not for monitoring needs) and the selected radiation of a determined wavelength may reveal not to be optimal. Finally, the plasma is not a pin-point source. As a final result, this improved method has still a number of limitations.

Moreover, in reality, the insulating layers cited above and particular the SiO2 layer 15 that have been formed by LPCVD techniques, are known to have low thickness reproducibility. As a result, the thickness of the deposited SiO2 layer 15 and the composition of the deposited material may significantly vary from one wafer to another in a same lot of wafers and from run to run for the same lot of wafers in the course of fabrication. Consequently, the thickness of the SiO2 layer 15 is no longer given by its theoretical value E but must be approximated by a value equal to E +- e, wherein e represents the admitted error on the thickness due to process variations during the LPCVD deposition. Typically, e is equal to about 10% of the initial thickness of the SiO2 layer 15. So that, in reality, if Exf is the final etched thickness, the final thickness of the remaining SiO2 layer is given by Eyf = (E +- e) - Exf and this value Eyf may be different from the given thickness value Ef that is finally desired. In other words, the error +- e relative to the original thickness E of the SiO2 layer 15 is reported to the real final thickness, i.e. Eyf = Ef +- e . The interferometric method thus provides an accurate and continuous measurement of etched thickness Ex (and then to stop etching when a determined thickness Exf has been removed) but unfortunately not of the current thickness Ey of the SiO2 layer 15 which remains on the silicon substrate and thus of the real final thickness Eyf at the end of the etch back operation. This results of the lack of compensation of the thickness error +- e, because the real final thickness Eyf of the remaining SiO2 layer 15 that is obtained at the end of the etch process is not directly available in real time for comparison with the said given thickness Ef.

This will be better illustrated by reference to Fig. 2(a). Now turning to Fig. 2(a), there is shown the sine wave curve labelled 19a that is theoretically generated by the photo-diode of the spectrometer. In reality, due to the presence of harmonics in the signal that is outputted by the spectrometer, this signal is periodic but not sine wave shaped. In the case of normal incidence, two successive extrema (minima to maxima or conversely) which correspond to a half period are separated by a distance d according to relation d = L/4*N, wherein L is the wavelength and N the refractive index of the SiO2 layer 15. In turn, the etch rate ER and the etched thickness during such a half period may be correlated by relation ER = 2*d/T, wherein T is the period of the periodic signal. Because of the thickness error e due to process variations mentioned above, it is clear that the current thickness Ey depends on the real thickness value of the SiO2 layer 15, i.e. E +- e as depicted in Fig. 2(a). Curve 19a passes by a maximum at interface 16a. Process variations thus lead to an error on the determination of Ey, finally resulting in stopping the etching process at a final thickness value Eyf of the remaining SiO2 layer 15 which may be significantly different from the said given thickness Ef that is finally desired.

On the other hand, there are also composition differences in the deposited materials forming the various layers of stack 12 mentioned above with respect to the expected compositions. In particular, this results in slight differences in the nominal refractive index N of the SiO2 layer 15 and more generally of the refractive index of all the other layers forming the said stack 12. In addition, these other layers may have variable thicknesses with regard to their respective nominal thickness, producing thereby significant topography differences. Finally, these differences between product wafers of a same lot are a major source of concerns. These differences generally result from process variations that are inherent to any semiconductor devices manufacturing technology. The sine wave curve 19a of Fig. 2(a) is illustrative of a perfect adaptation between the wavelength L of the monochromatic radiation and the nominal refractive index N of the SiO2 layer 15 and more generally of the optical characteristics of stack 12). As far as the structure 10 of Fig. 1 is concerned, the real value of the refractive index is given by N +- n, with the nominal thickness N = 1,48 and the error n equal to 0,002, i.e. the real value of N vary between about 1,46 and about 1,50. As soon as there is a discrepancy between the selected wavelength and the refractive index, there is a degradation in the signal outputted by the spectrometer as illustrated by curve 19b in Fig. 2(b). In this case, monitoring the dry etch process to detect the etch end point is no longer possible.

The typical value of the thickness E of SiO2 layer 15 is thus equal to 650 +- 65 nm. This value is to be compared with the desired thickness of the layer 15 remaining after the planarization step, given in this instance by Ef = 100 +- 5 nm. As a result, the error e = 65 nm related to the nominal thickness E = 650 nm of the SiO2 layer 15 is reported to the thickness of the remaining SiO2 layer 15 in its totality, while the thickness error on the remaining SiO2 layer 15 that is sought should be equal or less than 5 nm. It is important to notice that the thickness error e = 65 nm is of the same order of magnitude that the thickness Ef = 100 nm of the remaining SiO2 layer 15. The major problem to be solved here is thus to get rid of the thickness error e and of the refraction index error n due to composition differences that result of process variations inherent to the fabrication of structure 10.

### SUMMARY OF THE PRESENT INVENTION

The present invention aims to provide a method and an apparatus for monitoring the dry etching process of a structure comprising a dielectric film formed onto a substrate. The main purpose is to etch the dielectric film (e.g. the SiO2 layer 15 in Fig. 1) whose nominal thickness E is subject to an error e (due to process variations) down to a given thickness Ef measured from the interface between the bottom of said dielectric film and the substrate. Said given thickness is accurately defined in the product specifications. Another purpose is to get rid of the error n on the nominal refractive index N, and more generally of optical characteristic dispersions in stack 12. Typically, the substrate is part of a semiconductor wafer and consists of a silicon substrate coated by a layer of an insulating material (e.g. the composite SiO2 13/Si3N4 14 layer in Fig. 1).

As far as the apparatus of the present invention is concerned, in a preferred embodiment, the major innovation consists in the use of a multi-wavelength light source, such as a mercury lamp, that generates a light containing at least two radiations having specified wavelengths. These wavelengths L1 and L2 are greater than a minimum wavelength Lmin such as Lmin = 4*N*e . This light illuminates a large portion of the wafer (incorporating the said structure) that is placed in the dry etching equipment as standard at substantially the normal angle of incidence via an optical fiber and a collector lens. The reflected light is applied to two spectrometers, each being adapted to process one radiation. The analog signals that are outputted from the spectrometers are illustrative of the interferences in the reflected light. These signals are converted in digital signals in respective A/D converters then applied to a digital computer for signal processing and analysis. The digital computer processes said digital signals to generate filtered and normalized primary signals S1 and S2, and respective derivative signals S'1 and S'2 after numeric filtering thereof. It is recommended to have a phase shift (e.g. a quarter of period) therebetween.

According to the method of the present invention, it is first determined the parameters that specify the etch end point and constitute the etch end point criteria. The nominal thickness E of the dielectric film allows the determination of the number of periods of the primary signal S (S means either S1 or S2) between the top of the dielectric film and the film/substrate interface. Experiments show that primary signal S has an extremum (e.g. a maxima) at the film/substrate interface. Next, the said given thickness Ef is also converted in terms of periods. It is then possible to identify the last extremum of signal S before the given thickness Ef is attained. The last extremum is at a full period (or a multiple thereof) distance from said interface. A delay must be reserved to perform certain selection tests and measurements before the last extrema is attained. On the other hand, it is also required not to start any signal processing by the computer before the numeric filters are stabilized. Now, an extremum on the curve can be selected in the authorized period which reserves these delays. The time that is necessary to travel from the top of the dielectric film and this selected extremum is referred to as the RATE TIME RT (RT means either RT1 or RT2). The RATE TIME RT is thus a time disregarding period which takes into account all these timing requirements. The number of zeroes X (X means either X1 or X2) between this selected extremum (excluded) and the last extremum can then be determined. The manner the primary signal S reaches said selected extremum (up-going or down-going transition) is also identified and represented by a sign A (A means either A1 or A2). The remaining thickness D (D means either D1 or D2) which corresponds to the distance between the last extremum and the given thickness can be easily determined. One can then define a STOP THICKNESS parameter ST (ST means either ST1 or ST2) represented by these data A X D. Finally, the etch stop is accurately defined by the etch end point criteria comprised of the RATE TIME RT and the STOP THICKNESS ST and by the etch rate which is measured in-situ and on-line for the wafer being etched. The RATE TIME and STOP THICKNESS parameters may be determined either by computations (at least for coarse approximation) or by processing a specimen wafer (a sample or an ideal product wafer) in a preliminary training step. The etch end point criteria are inputted in the computer.

Now the product wafers can be processed under the control of the computer. First, the computer is waiting the time disregarding period (corresponding to the RATE TIME RT) before analyzing the primary signal S. Once this period of time has elapsed, it identifies the said selected extremum and it counts the number X of zeroes to detect the last extremum. During this time, it also proceeds to selection tests to determine which wavelength is the most adequate and it makes measurements to determine the etch rate ER (ER means either ER1 or ER2). These operations are performed for each primary signals S1 and S2. Before the earliest of the two last extrema is reached, the computer selects the best primary signal S1 or S2 as the result of the selection tests mentioned above. Finally, it determines the remaining etching time dt to travel from the last extremum of the selected primary signal to the given thickness. This time dt is given by relation dt = D/ER. In fact, the search of the extrema of the primary signals S1 and S2, the selection tests and the measurements mentioned above are preferably conducted on the derivative signal S'1 and S'2 for maximum accuracy.

The method of monitoring the dry etching of a dielectric film down to a given thickness of the present invention thus significantly departs from the known interferometric monitoring techniques described above, wherein the etched thickness is measured from an imprecise origin, i.e. the top of the dielectric film. Unlike, according to present method, the monitoring is performed from the dielectric film/substrate interface to stop etching when the desired given thickness has been reached. In addition, in lieu of using one wavelength radiation (that could produce very poor interference signals in case of misadaptation with the refractive index of the dielectric film), at least two wavelengths are used. These problems which result of variations in the nominal thickness and refractive index of the dielectric film that are inherent to the manufacturing process are now overcome. Therefore, according to the method and apparatus of the present invention, the dry etching of the dielectric film down to a given thickness is performed with great accuracy and reproducibility. The method of the present invention finds a wide range of applications and technical domains, not only in the planarization of layers as illustrated above by reference to Fig.1, but more generally in the polishing of any dielectric film down to a given thickness.

### OBJECTS OF THE PRESENT INVENTION

It is therefore a primary object of the present invention to provide a method and an apparatus for monitoring the dry etching process of a dielectric film formed on a substrate down to the desired thickness (referred to as the given thickness) of the dielectric film that must remain on said substrate.

It is another object of the present invention to provide a method and apparatus for monitoring the dry etching process of a dielectric film formed on a substrate down to the desired thickness wherein the etch end point criteria are determined from the dielectric film/substrate interface and not from the top of the dielectric film as it has been practiced so far.

It is another object of the present invention to provide a method and apparatus for monitoring the dry etching process of a dielectric film formed on a substrate down to the desired thickness with great accuracy and full reproducibility for all wafers of a lot.

It is still another object of the present invention to provide a method and apparatus for monitoring the dry etching process of a dielectric film formed on a substrate down to the desired thickness that is independent from film thickness and composition variations due to the manufacturing process.

It is still another object of the present invention to provide a method and apparatus for monitoring the dry etching process of a dielectric film formed on a substrate down to the desired thickness that are based upon the use of a large light beam including at least two radiations having different and specified wavelengths and the selection of the best one.

It is still another object of the present invention to provide a method and apparatus for monitoring the dry etching process of a dielectric film formed on a substrate down to the desired thickness wherein said specified wavelengths are greater than a minimum value given by 4*e*N (e is the thickness error and N the refractive index of the dielectric film).

It is still another object of the present invention to provide a method and apparatus for monitoring the dry etching process of a dielectric film formed on a substrate down to the desired thickness that are based upon the use of a small light beam a specified wavelength that is greater than a minimum value given by 4*e*N (e is the thickness error and N the refractive index of the dielectric film).

It is still another object of the present invention to provide a method and apparatus for monitoring the dry etching process of a dielectric film formed on a substrate down to the desired thickness wherein the etch rate is measured in-situ and on-line for the product being etched for maximum accuracy.

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings.

### BRIEF DESCRIPTION OF THE DRAWINGS

Fig. 1 shows a schematic view of a silicon structure provided with an isolation trench undergoing fabrication at the step of planarizing a dielectric (TEOS SiO2) film whose thickness is subject to an error e down to a given depth to illustrate the resulting inherent error e on the thickness of the remaining layer when standard time based or interferometric techniques are used.

Fig. 2 is comprised of Fig. 2(a) and Fig. 2(b) which respectively shows the interference signal which is obtained from the interferometer when the refractive index of the dielectric film is or is not well adapted to the selected wavelength.

Fig. 3 is a schematic view of the apparatus of the present invention which includes a polychromatic mercury lamp that illuminates a large area of the wafer at a normal angle of incidence and two spectrometers, each being adapted to a specified wavelength, to generate corresponding interference signals.

Fig. 4 shows an enlarged view of the collimation section of the apparatus of Fig. 3.

Fig. 5A shows a schematic representation of the waveforms of signals S1 and S2 that are obtained for a specimen wafer (an ideal product wafer) at the output of the spectrometers for each selected wavelengths L1 and L2 and the signals S'1 and S'2 that are respectively derived therefrom by numeric filtering.

Fig. 5B shows the signals of Fig. 5A when the thickness error e is taken in consideration.

Fig. 6 shows the flow chart that illustrates the essential steps of the method of monitoring the dry etching of a dielectric film formed on a substrate down to a given thickness according to the present invention.

Fig. 7 shows the real waveforms of signals S1/S'1 and S2/S'2, in a case where both wavelengths are adapted to the refractive index N of the dielectric film.

Fig. 8 shows the real waveforms of signals S1/S'1 and S2/S'2, in another case where the wavelength of signal S2 is not adapted to the said refractive index N.

### DESCRIPTION OF THE PREFERRED EMBODIMENTS

### DESCRIPTION OF THE SYSTEM

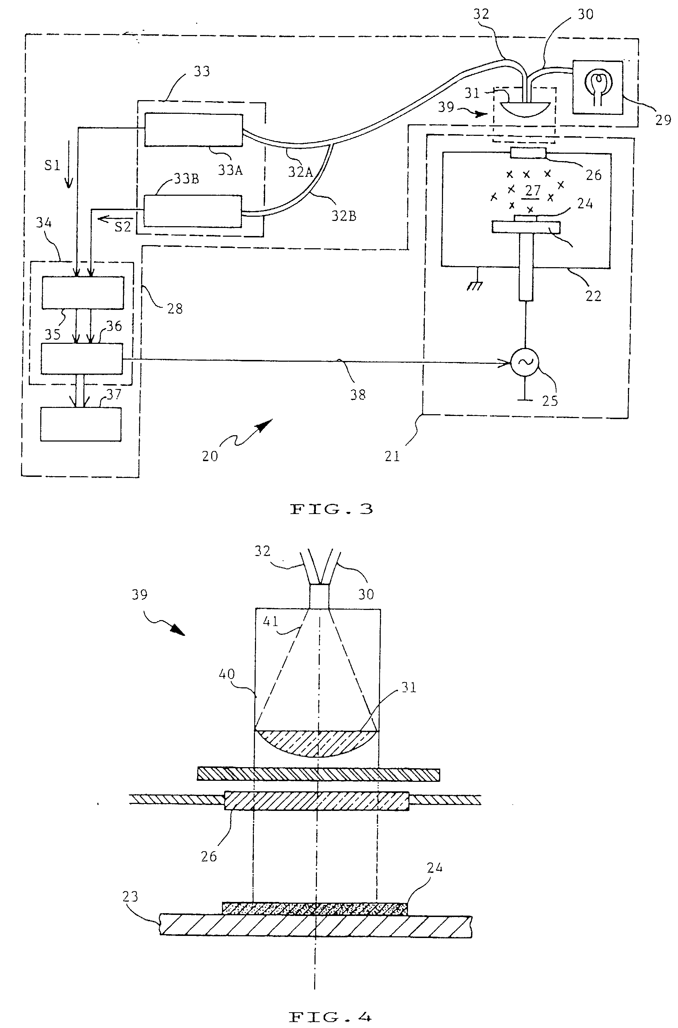

Now turning to Fig. 3, there is shown the etching and monitoring system 20 that is adapted to carry out the method of the present invention. System 20 first comprises a dry etching equipment 21 which essentially consists of an etch-treatment chamber 22 enclosing a planar-shaped susceptor 23 that holds the article to be processed, typically a silicon wafer 24, and a RF power supply source 25. According to the teachings of the present invention, it is essential the etch-treatment chamber 22 be provided with at least one window or view port 26 made of a material that is transparent for the wavelengths used, so that the wafer 24 can be illuminated with an adequate angle of incidence. For a number of reasons, a normal angle of incidence is by far preferred. With the particular implementation shown in Fig. 3, the view port 26 is located at the top wall of chamber 22. An appropriate etching equipment in that respect is the AME precision 5000 commercially available from APPLIED MATERIALS INC, Santa Clara, USA, a RIE tool which includes a plurality of single wafer plasma etch reactors. With this type of tool, susceptor 23 is the cathode and the chamber wall forms the other electrodewhich is connected to the ground. The plasma 27 generated between the two electrodes contains species that are representative of the etching conditions. While etching is performed, the emission from these species changes in intensity as a function of time, etched material and surface modifications.

System 20 further comprises the monitoring apparatus 28 of the present invention. A light source 29 illuminates the wafer through top view port 26 via a optical cable 30 and a collector lens 31. According to the teachings of the present invention, to get rid of possible optical characteristic dispersions in stack 12 between the product wafers due to process variations, at least two specified wavelengths L1 and L2 are recommended. In that respect, different practical implementations of the light source 29 can be envisioned, for instance, either white light sources (such as xenon or halogen lamps) or polychromatic light sources (such as low pressure mercury (Hg) or argon (Ar) lamps) are adequate. Preferably, light source 29 is a low pressure mercury pen ray, such as model 90-0020-01 sold by UVP, San Gabriel, CA, USA which delivers eight radiations having wavelengths in the 254-579 nm range. The combination of two monochromatic lasers such as model 1108P sold by UNIPHASE, Manteca, CA, USA (each being tuned to generate one of said two specified wavelengths) or mixed lamp/laser solutions are adequate as well. The choice of a mercury lamp to fit external light source 29 is preferred for a number of reasons. First of all, it offers a wide choice of wavelengths, secondly it is a very stable source of light whose intensity may be adjusted independently of the plasma conditions and finally because of its low cost and its reduced dimensions compared to a laser when short wavelengths are used. Still according to the present invention, optical cable 30 is comprised of a plurality of elementary optical fibers adapted to transport such a determined wavelength. The light reflected back from the surface of wafer 24 is detected by optical cable 32 which is comprised of optical cables 32A and 32B, as illustrated in Fig. 3 that have the same construction as optical cable 30. The elementary optical fibers forming said optical cables 30 and 32 are arranged to have substantially the same optical axis perpendicular to the wafer 24. In a particular implementation, they are assembled close together and at random to form a single bundle of fibers. Optical cables 30 and 32 are constructed from fibers of the bundle. Optical cables 32A and 32B are constructed from fibers forming optical cable 32. However, a set of three different optical cables 30, 32A and 32B would be adequate as well. Optical cables 30 and 32 are viewing the wafer 24 at a normal angle of incidence. Lens 31 provides a parallel light beam through top view port 26 on the wafer 24. Each optical cable must provide a solid angle that allows illumination/capture of the emitted/reflected light from a relatively large area of the wafer 24. Optical cables 32A and 32B are respectively connected to spectrometers 33A and 33B. An adequate spectrometer is the model referenced by trade name DIGISEM that is commercially available from SOFIE INST, Arpajon, France. This model of spectrometer is tunable over a wide-range spectrum of radiations and, in the present case, is tuned on a particular wavelength of the polychromatic light emitted by mercury lamp 29. Each spectrometer comprises a monochromator and a detector. The transmitted light is received by the motor-driven monochromator which filters out all radiation wavelengths except the one to be monitored. The selected radiation is then received by the detector. The detector may be either a low-noise diode detector or preferably a low-noise photo-multiplier tube combined with an analog filter and an amplifier. Analog interference signals that are outputted by the amplifying sections of spectrometers 33A and 33B respectively are applied to a processing/analyzing unit 34 comprised of an unit 35 including two I/V converters, anti-alaising (low frequency) filters, two A/D converters and buffers as standard and an processing/analyzing unit 36 such as a software operated digital computer. Finally, computer 36 generates primary signals S1 and S2 which are representative of the analog interference signals and respective derivative signals S'1 and S'2 by numeric filtering. A printer 37 (or a chart recorder unit or a plotter or a visual display) is connected to computer 36. Printer 37 allows the printing of analog signals that are generated according to the present monitoring method. Finally, computer 36 is able to monitor operation of the etch chamber 22 through control line 38 which is connected to the RF frequency power supply source 25 via a remote control unit. This line 38 allows automatic switch-off of the etching process at end-point detection, when the desired given thickness Ef has been attained. Note that only one spectrometer 33 could be used as well, should an advanced spectrometer such as model SDA sold by SOFIE INST. Arpajon, France be used. This type of spectrometer is provided with a multi-channel photo-diode array.

Fig. 4 shows in more details the collimator section referenced 39 which essentially consists of housing 40 which encloses collector lens 31. Housing 40 has a transparent bottom facing top view port 26 and is adapted to receive optical cables 30 and 32 which are connected to its top. The shape of the light beam that is directed onto the sample wafer (via optical cable 30) and reflected therefrom (via optical cable 32) is referenced 41 in Fig. 4. As illustrated in Fig. 4, a large area of wafer 24 is illuminated.

### DESCRIPTION OF THE METHOD OF THE PRESENT INVENTION

Before the etch process of the product wafers of a lot takes place, a few preliminary steps for calibrating the system 20 for these wafers may be required. In essence, it is essential that at least one adequate wavelength be selected and the etch end point criteria be determined. Said wavelength and criteria must be adapted to the product wafers in consideration. In the following description, reference will be made to two wavelengths to get rid both of the thickness error and of the refractive index differences mentioned above.

### Calibrating system 20

### A) Selection of wavelengths L1 and L2

Criteria for selecting adequate wavelengths will now be given. This selection will in turn determine the choice of an adequate mercury lamp 29. The wavelengths are selected using data that can be found in the product specifications. As a matter of fact, in a product wafer, the real thickness of the SiO2 layer 15 is given by E +- e, where e is the film thickness error and its real refractive index is given by N +- n where n is the refractive index error. The refractive index error n is the major source of optical characteristic dispersions caused by thickness and compositions differences in all the layers forming stack 12. These errors e and n result from the process variations from wafer to wafer mentioned above. In our example, E is equal to 650 nm, e is equal to 65 nm (assuming e = 10%), N is equal to about 1,48 and n is equal to about 0,02. First of all, the selected wavelengths L1 and L2 must be adapted to the particular refractive index N of the SiO2 layer 15 and more generally to the optical properties of stack 12. In essence, the SiO2 layer 15 must be transparent to both wavelengths. Secondly, it is essential to have the selected wavelengths L1 and L2 greater than a theoretical value Lmin given by relation Lmin = 4*N*e, i.e. L1 > Lmin and L2 > Lmin. This choice is particularly important to get rid of optical path dispersions from one wafer to another or from the wafers of one lot to another as mentioned above. In the following description, it is assumed that L2 > L1 by convention. Thirdly, it is desirable to have the lowest possible values for L1 and L2 for sake of accuracy. Fourthly, it is required to have the corresponding primary signals S1 and S2 with a different behavior, at least in the period of time where some selection tests and measurements (to be described in more details hereafter), are to be made on the product wafer. In particular, if said wavelengths L1 and L2 are selected different but relatively close of one another, it is recommended to introduce a desired phase shift between signals S1 and S2, typically a quarter of a period. Finally, combining these criteria will efficiently prevent any subsequent distortion of signals S1 and S2 caused by the parasitic reflections due to topology and optical properties of stack 12. Let us consider a simple numerical example with e = 65 nm and an average value of N = 1,48 so that Lmin = 385 nm. The mercury lamp mentioned above which contains discrete wavelengths in the 254-579 nm range is therefore adequate in that respect, because the closest wavelength values that are just above Lmin are given by L1 = 404,7 nm and L2 = 435,8 nm. These values meet all above recited conditions. Should there were no admitted error on the refractive index N of the SiO2 layer 15 and more generally, no dispersions of the stack 12 optical properties because of the technology used, only one wavelength could be used. Likewise, the monitoring method of the present invention could be implemented with one wavelength if it was applied to a very specific dedicated site of the product wafer, but this approach does not sound interesting in an productive manufacturing environment.

### B) Determination of the etch end point criteria

For convenience, in the following description, the determination of the etch end point criteria will be made by reference to the graphs depicting the primary signals S1 and S2. These graphs can be obtained through theoretical computations based on the product specifications. They can also be obtained from etching either a product or a sample wafer (that is provided with the stack structure of Fig. 1). Sample wafers are extensively used for deposited film characterization. The sample wafer can be etched until the top of the Si3N4 layer 14 is exposed, so that the totality of the interference curves representing signals S1 and S2 is obtained. These techniques provide the operator or the computer with a coarse approximation of the behavior of the system 20. The system 20 can also be calibrated with a product wafer, either an ideal product wafer (an ideal product wafer is a wafer whose thickness of the SiO2 layer 15 is equal to the nominal value, i.e. E = 650nm) referred to hereinbelow as a specimen wafer or any product wafer of the lot. However, in the latter case, if it is an expensive wafer, it is recommended to stop etching before the estimated etch end point is reached, and then to measure the remaining thickness to be etched (in order to determine the etch end point criteria) and finally to terminate the etching operation. In this instance, the etching is conducted according to the time thickness control technique mentioned above. The use of an inexpensive sample wafer has obvious cost advantages over the use of a product wafer but it may behave differently because of their topographical differences. The best solution appears to be in the combination of a coarse determination of the etch end point criteria by such theoretical computations and to use a product wafer of the lot which was in the middle of the carrier during the previous TEOS SiO2 deposition step for fine adjustment thereof. Once adjusted that way, the remaining product wafers of the lot can be processed without special care. As a result, if a costly product wafer is used to terminate the calibration of system 20, it will not be wasted. The determination of said etch end point criteria will be described hereinbelow with reference to the etching of a specimen consisting of an ideal product wafer for sake of illustration.

First the specimen wafer is placed in the RIE tool 21. A beam of a light including the two radiations of wavelengths L1 and L2 is generated by mercury lamp 29 and coupled to the top view port 26 to illuminate the specimen wafer 24. The reflected light beam which results from wafer illumination is applied to spectrometers 33A and 33B via optical cables 32A and 32B. Processing unit 34 and printer 37 are turned on. The system 20 is then ready for operation.

As soon as the etch process and the monitoring thereof have been started, spectrometers 33A and 33B respectively generate analog interference signals S1 and S2 that are illustrative of the intensity of the reflected light as a function of the elapsed time for their respective radiation. After conversion in digital data and filtering, signals S1 and S2, still referenced S1 and S2 for sake of simplicity, are filtered in numeric filters to generate respective derivative signals labelled S'1 and S'2. Derivative signals S'1 and S'2 are obtained by numeric filtering of signals S1 and S2 using a mathematical algorithm for harmonic elimination as known for those skilled in the art. The purpose of this signal processing is to generate a derivative signal that crosses an arbitrary X axis when the corresponding primary signal passes by an extremum. Processing the zeroes of the derivative signals is more accurate than processing extrema of the primary signals, because of the abrupt transients thereof. In the present case, the numeric filtering that has been implemented thus broadly operates like a derivation of the primary signal.

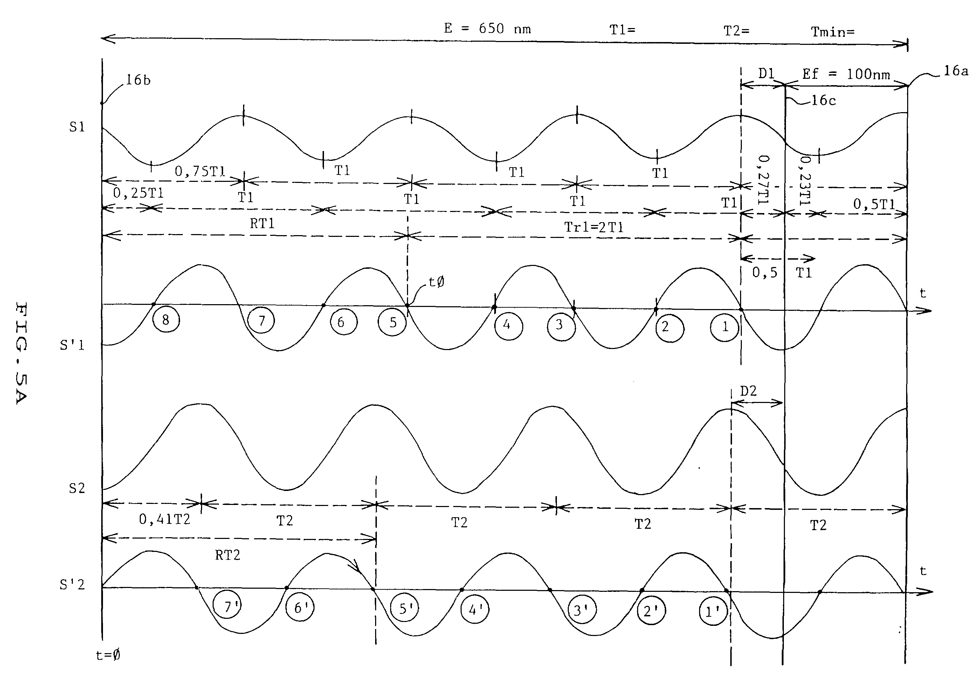

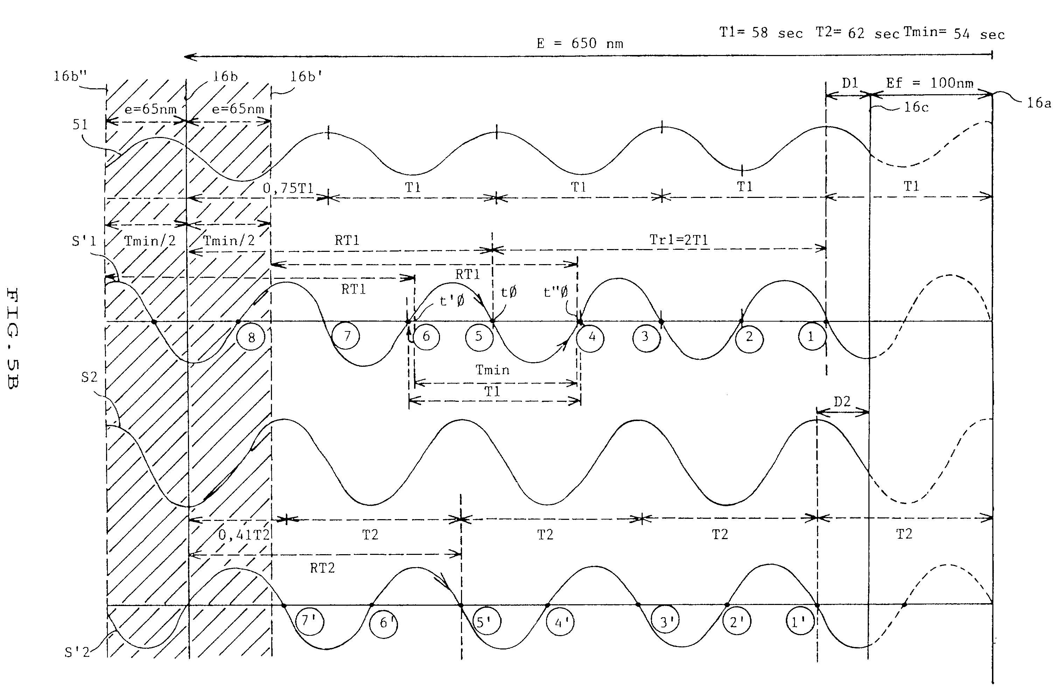

Now, the determination of the two main parameters of the monitoring method of the present invention, i.e. the STOP THICKNESS ST and the RATE TIME RT for each wavelength L1 and L2 preferably requires to draw the graphs of the primary and derivative signals. Fig. 5A shows an idealized graph representation of the waveforms of primary signals S1 and S2 and derivative signals S'1 and S'2, that have been obtained for the specimen wafer in consideration. Quite similar schematic curves would have been obtained by the theoretical computations mentioned above. In Fig. 5A, the various surfaces/interfaces described above by reference to Fig. 1 are shown for sake of clarity.

The STOP THICKNESS and the RATE TIME parameters (they are cross-related in some respect) constitute the etch end point criteria that are essential to the implementation of the monitoring method of the present invention will be discussed hereinbelow in details.

### The STOP THICKNESS parameter

According to a principle of the present invention, the etch end point is not determined from the TEOS surface 16b as practiced in the techniques of the prior art described above (with the reported inconveniences), but from the TEOS SiO2/Si3N4 interface 16a. In particular, the determination of the STOP THICKNESS parameter ST is first based on the findings that the interference curve of a primary signal S (S means either S1 or S2) has a maxima at the TEOS SiO2/Si3N4 interface 16a as shown in Fig. 5A. Consequently, if we consider that the nominal thickness E of the initial SiO2 layer 15 and the final desired thickness Ef thereof which must remain at the end of the etching process have a determined value, at a given distance from the interface 16a, the shape and the number of periods T (T means either T1 or T2) of signal S is identical whatever the wafer and the thickness error e due to process variations. In addition, because of the particular choice made for the selected wavelength L (L means either L1 or L2), one can assure that surface 16c which corresponds to the given thickness Ef is located between two consecutive extrema of the primary signal S or two zeroes of the derivative signal S' (S' means either S'1 or S'2), i.e. a half-period. The last extremum is thus located at a distance from interface 16a corresponding to a full period T in the case illustrated in Fig. 5A or a multiple thereof more generally. There is thus a last zero of the derivative curve S' corresponding to this last extremum located at a determined distance D (D means either D1 or D2) of surface 16c. In summary, the number of times this primary signal S pass by an extremum between surfaces 16a and 16c is perfectly determined. Practically, this is performed by counting the number of zero crossings of the derivative signals S' for increased accuracy until surface 16c is reached.

For the specimen wafer, the nominal thickness E allows computation of the theoretical number of periods K1(1) between surface 16b and interface 16a for primary signal S1. This number is such as K1(1) = (2*N*E)/L1 = (2*1,48*650)/404,7 = 4,75 T1 (the period of signal S1). As apparent from Fig. 5A, this number K1(1) represents the sum of 0,5 period between interface 16a (at a maxima) and the first minima (from said interface 16a), next four intermediate full periods and finally 0,25 period to reach surface 16b. On other hand, the value of the thickness of the TEOS layer 15 which should remain at the end of the etch process, illustrated by surface 16c is known and equal to Ef. In turn, this value can be converted in a fraction of period T1. In the present instance where Ef = 100 nm, this number K1(2) is given by K1(2) = (2*N*Ef)/L1 = (2*1,48*100)/404,7 = 0,73 T1 . This value is the sum of 0,5 T1 (between the two extrema just mentioned above) and 0,23 T1. All these values are apparent in Fig. 5A where they have been reported. Finally, the number of zeroes between surfaces 16b and 16c, still for the nominal thickness E, is determined from K1(1) - K1(2) = 4,02 T1 = (8*1/2 + 0,02) T1 , so that K1(3), the integer number of zeroes is given by K1(3) = 8. These zeroes are labelled by a number ranging from 1 to 8 that is encircled in Fig. 5A. As far as signals S2 and S'2 are concerned, corresponding numbers K2(1) and K2(2) may be established. We have K2(1) = (2*N*E)/L2 = 4,41 T2 (T2 is the period of signal S2), K2(2) = (2*N*Ef)/L2 = 0,68 T2 and K2(1) -K2(2) = 3,73 T2, so that K2(3) = 7 with the figures given above. These zeroes are labelled by a number ranging from 1' to 7' that is encircled in Fig. 5A.

However, according to the monitoring method of the present invention, the counting of zeroes is started after a certain delay the etch process has begun. This delay, referred to hereunder as the RATE TIME RT (RT means either RT1 or RT2), is determined through a few experiments that are conducted on the specimen wafer. The rate time RT is a disregarding period which takes in account first the time that is necessary to perform a certain number of operations during wafer etching, essentially the tests for selecting which primary signal is the best (and thus which wavelength is the most adequate) and to measure the etch rate ER, and second the time that is necessary for initializing the numeric filters and normalizing the primary signals S1 and S2. The method for determining the rate time RT will be described hereafter in more details. Now turning to Fig. 5A where the last zero is labelled (1) in curve S'1, let us assume the rate time RT1 for signals S1 and S'1 corresponds the zero labelled (5) at elapsed time t0. As apparent from Fig. 5A, the number X1 of zeroes between the zero labelled (5) (not included in the count) and the last zero labelled (1) is equal to 4. Number X1 is the first component of the ST1 parameter. Similar reasoning applies to signals S2 and S'2, so that X2 is also found to be equal to 4 (assuming the rate time RT2 shown in Fig. 5A which corresponds to the zero labelled (5'). As apparent from Fig. 5A, the rate time RT2 for signals S2 and S'2 is different from rate time RT1, and there is a non negligible periodicity difference between primary signals S1 and S2, in particular, in the active area for a duration Tr (Tr means either Tr1 or Tr2) of about two periods T in the particular case illustrated in Fig. 5A where some selection tests and measurements are made.

The second component of parameter ST is the distance D (D means either D1 or D2) between the last extremum of primary signal S and surface 16c. The distance which corresponds to one period T, is equal to L/2*N. Distance D is then easily obtained by relation D = L/2*N - Ef. Still using the above figures, D1 = 404,7/(2*1,48) - 100 = 37 nm and D2 = 435,8/(2*1,48) - 100 = 47 nm.

Finally, the third component, referred to by letter A, will be related to the manner the zero crossing is effected by the derivative signal S' after the rate time RT has elapsed still for the specimen wafer, i.e. depending on it is achieved in a crescent or decrescent part of the derivative signal S'. As apparent from Fig. 5A, the zero labelled (5) of signal S'1 is reached by a down-going transition. However, in other cases it could have been reached as well by a up-going transition. It is worthwhile to introduce this component in the ST parameter, for full description thereof. In the first case (down-going or decrescent transition), component A is represented by a first value or sign, (e.g. A = +), and by a second value or sign, (e.g. A = -) in the other case.

Therefore, in the most general manner, the STOP THICKNESS parameter ST is represented by the word A X D (D is given in nanometers). The STOP THICKNESS parameter ST is established for each of wavelengths L1 and L2. With the experiments described hereinabove by reference to the specimen wafer as illustrated by Fig. 5A, the respective STOP THICKNESS parameters ST1 and ST2 for each wavelength, are thus represented by ST1 = + 4 37 and ST2= + 4 47. Because in this case, the two wavelengths L1 and L2 (and thus the corresponding periods T1 and T2) are slightly different, numbers X1 and X2 have equal values (X1 = X2 = 4), but the distance components D1 and D2 are different.

### The RATE TIME parameter

On the one hand, the numeric filtering requires a determined delay before the numeric filters are stabilized and the primary signals normalized to be able to provide reliable results adapted to a manufacturing environment. On the other hand, a certain time is required to proceed to the necessary steps of testing the primary signals S1 and S2 to determine which one is the best, and thus which wavelength is to be selected for the monitoring of the etch process. During this same period of time, a few measurements are conducted to determine the average etch rate ER that is necessary to calculate the remaining time of etching when the last extremum has been reached for the product wafers. It is important to notice that the etch rate ER measurement is very accurate, because it is conducted on-line and in-situ, so that it perfectly corresponds to the real etching condition of the wafer (specimen or product) undergoing etching. All these delays are taken in consideration by the RATE TIME RT parameter, briefly introduced just above, is therefore another essential parameter of the method of the present invention. Now, let us give the basic rules to be used for the RATE TIME RT determination.

The determination of the RATE TIME RT first requires an estimation of the time that is necessary to proceed to certain selection tests and measurements. From experiments it has been demonstrated that although one test over a half period could be sufficient to determine which primary signal S1 or S2 is the best (and thus which wavelength is the most adequate) and to measure the etch rate, it seems that the optimized number of selection tests is about two. In this case, the total test period is equal to a full period T. However, if there is no special time constraints, more tests can be made for greater accuracy. The method will be described by reference to signals S1 and S'1 illustrated in Fig. 5A for sake of simplicity. If the last zero (1) of signal S'1 is excluded for practical reasons, this means that zeroes (2),(3) and (4) are required for the selection tests. This period of time being reserved, the first zero now available is the zero labelled (5), which corresponds to a duration Tr1 equal to two periods T1 to reach the zero labelled (1). This duration Tr1 appears also satisfactory to proceed to the measurements that are necessary to determine the etch rate ER1. As a result, still for this specimen wafer, and only as far as the selection tests and etch rate measurements are concerned, an adequate RATE TIME RT1 would be 4,75 T1 - 3 T1 = 1,75 T1. Starting from surface 16b at the nominal thickness E, the time t0 that is necessary to reserve this delay RT1 is given by t0 = RT1 = (1,75*L1*60)/(140*2*N) = 103 sec (assuming an average etch rate ER1 = 140 nm, an estimated value or the average value measured on a preceding lot of wafers). It just remains now to check that this delay RT1 is adequate to have the numeric filters stabilized and primary signals normalized. It has been shown that the stabilization time is much inferior to a half period T1, i.e. about 30 sec in the described example of Fig. 5A. Note that zeroes labelled (6) and (7) instead of (5) could have been adequate as well with regards to the test/measurement time Trl, should the above mentioned conditions as to stabilization of filters and normalization of signals be appropriately met. Similar reasoning applies to the determination of RATE TIME RT2. The RATE TIME RT is thus a determined period of time corresponding to the time interval required to the derivative signal S' to travel from surface 16b to the selected zero thereof, on either a crescent or a decrescent transition.

Now, these ST and RT parameters are inputted in computer 36 as the etch end point criteria of the product wafers to be subsequently etched. The etching of the specimen wafer is stopped as soon as the etch end point is reached and the specimen wafer is removed from the etching equipment 21. The remaining thickness of the TEOS layer 15 is measured and the STOP THICKNESS ST parameter adjusted is so required. System 20 is now calibrated and is ready for processing the remaining product wafers of the lot. For each product wafer, the computer is now capable to automatically determine the etch end point thanks to the ST parameter and it knows the delay, referred to as the time disregarding period t0 (equal to RT), it must wait before undertaking the signal processing. After this time disregarding period has elapsed, numeric filtering is effective, the primary signals are normalized and the computer is then capable to properly analyze the primary signal S1 and S2 as mentioned above.

### B) Monitoring the etch process of a product wafer

The difficulty of accurately etching to a given thickness is clearly illustrated in Fig. 5B, which directly derives from Fig. 5A. As apparent from Fig. 5B, the etching of a product wafer may begin at any point of the curves representing primary signals S1 and S2 in the hatched zone as a result of the thickness error e due to process variations.

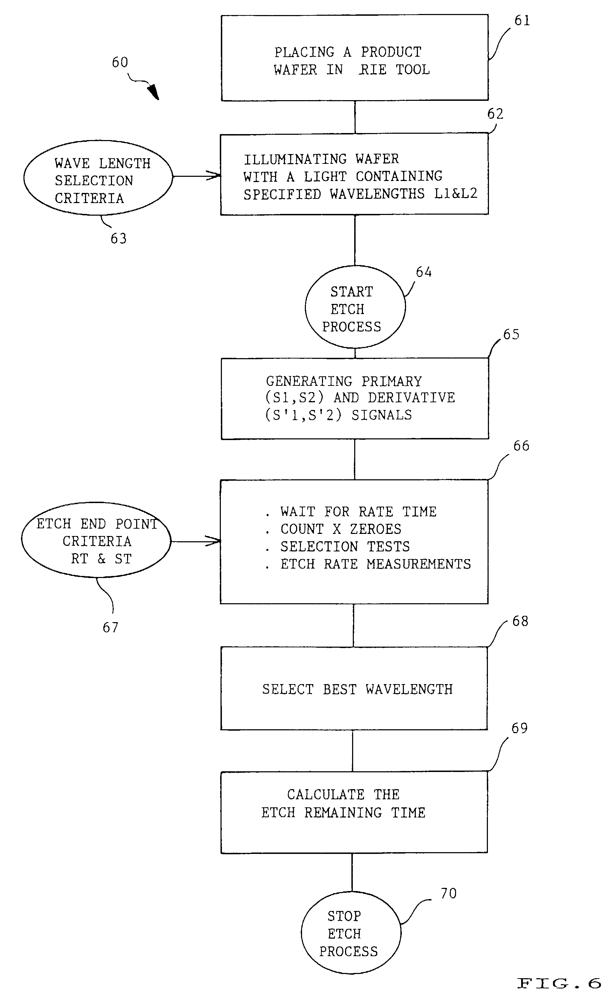

Assuming the etch end point criteria have been determined as described above, the flow-chart referenced 60 in Fig. 6 shows the essential processing steps of the method for monitoring the dry etching of a dielectric film down to a given thickness or STOP THICKNESS Ef of the present invention in order to illustrate the two principles at the base thereof. The first principle is to continuously monitor the remaining thickness of the SiO2 layer 15 from the SiO2/Si3N4 interface 16a and not to measure the etched depth from the the top surface 16b of the SiO2 layer 15. The second principle is to use at least two wavelengths whose values are determined by the thickness error e due to process variations. The use of two wavelengths allows to get rid both of the thickness error e and of optical characteristic dispersions in stack 12 and in particular of the possible misadaptation between a selected wavelength and the refractive index N of the SiO2 layer 15 that are similarly caused by said process variations. The essential steps of monitoring the etching of the product wafers of the same type as the specimen wafer used for calibrating the system 20 will be now described by reference to Fig. 6.

Once the system 20 has been calibrated, the first product wafer of the lot is introduced in the etching equipment 21 (box 61). The system is prepared as mentioned above and the wafer is illuminated by a light containing radiations having wavelengths L1 and L2 (box 62). These wavelengths L1 and L2 have the specified values according to box 63. The etch process is then initiated as indicated by box 64. Primary signals S1 and S2 and respective derivative signals S'1 and S'2 are generated by the computer (box 65). While the etch process progresses, the computer 36 is waiting for a delay equal to the RATE TIME RT before analyzing primary/derivative signals S1/S'1 and S2/S'2. Therefore, computer 36 draws the graphs of said pairs of signals S1/S'1 and S2/S'2 but does not analyze them until their respective RATE TIME RT1 and RT2 has elapsed. Then, the computer undertakes a number of steps (some being simultaneously performed) for each primary signal according to box 66. Basically, it counts the number X1 and X2 of zeroes to detect the last zero of derivative signals S'1 and S'2 before surface 16c corresponding to the given thickness Ef is reached. It proceeds to selection tests mentioned above, i.e. it compares the two pairs of signals S1/S'1 and S2/S'2 over the minimum period of time (in the present case a full period) to be capable to determine which pair is the best. It also calculates the etch rates ER1 and ER2. Before the earliest of the two zeroes (1) and (1') is reached, it selects the most adequate signal/wavelength couple and determine the remaining time dt1 or dt2 depending on the selected wavelength. Assuming the best signal pair is S1/S'1, as soon as the zero labelled (1) is reached, the computer counts down the remaining time dt1 (that was previously computed) to 0, and then it stops the etching process via line 38 in Fig. 3. As a result, the etch process terminates exactly at the etch end point point, i.e. at surface 16c. All these operations that are performed in box 66 using the etch end point criteria stored in box 67 will be now described in more details.

Still referring to signals S1 and S'1 for sake of simplicity, as apparent from Fig.5B, depending on the initial point of etching (somewhere in the hatched zone), the first zero met by the computer after the rate time RT1 has elapsed will be either the zero labelled (5) or the zero labelled (4). This uncertainty is no longer a problem, because, according to an essential characteristic of the present invention, all the inconveniences caused by the thickness error e due to process variations are now eliminated as it will now be demonstrated. This directly results from the choice of wavelength L1, such L1 > Lmin and the value of component A1 of the STOP THICKNESS parameter ST1 = A1 X1 D1 = + 4 37. Now, turning to Fig. 5B, if the product wafer is at the maximum thickness of the specification, i.e. E + e, the time disregarding period from the origin (t = 0 at surface 16b") corresponds to time t'0 on the time axis, just after the zero labelled (6). The first zero met by the computer is therefore the zero labelled (5) on a down-going transition (A1 = +) which is identified as such by the computer. The computer knows that it will have to compute four zeroes (X1 = 4) from this zero labelled (5), the latter being excluded from the count. On the contrary, if the product wafer is at the minimum thickness of the specification, i.e. E - e, the time disregarding period now corresponds to time t"0 from the origin (t = 0 at surface 16b'), just before the zero labelled (4). In this case, because the computer meets the first zero on an up-going transition, it knows that the four zeroes have to be counted immediately, with the zero labelled (4) included in the count. In both cases, the first zero met by the computer that is taken in consideration for counting, once the time disregarding period given by the rate time RT1 has elapsed, is the zero labelled (4). Similar reasoning applies to signals S2 and S'2. The specified choice made for selecting wavelengths L1 and L2 thus ensures to have the time disregarding period t0 centered around the zero labelled (5) strictly within one period T1. In other words, the time interval t'0 - t"0 which is equal to Tmin is inferior to period T1, as apparent from Fig. 5B. This feature is a determining factor to raise the uncertainty mentioned above.

To terminate the etch process at the desired etch end point, also requires determination of the remaining time dt. The remaining time is thus the time that is necessary to reach the etch end point at surface 16c from the last extremum. In turn, the remaining time dt requires the value of the etch rate ER to be determined. This etch remaining time dt is given by dt = D/ER wherein D is known from the stop thickness ST parameter. As a result, while the etch process is progressing, the etching rate ER is accurately determined in- situ for the product wafer being processed through a few measurements. Because this value cannot be easily obtained in real time, it is approximated by an average etch rate value on a preceding period, e.g. between zeroes labelled (4) and (2) of signal S'1 in Fig. 5B. Because, two successive zeroes of the S'1 signal are separated by a thickness reduction given by L1/4*N , a first measurement will be performed between zeroes labelled (4) and (3), then between zeroes labelled (3) and (2) in order to determine the respective etch rate values ER1(1) and ER1(2). Each measurement being made over an half-period, the two measurements are made within one period T1. To date, the minimum time to perform the etch rate measurement appears to be a half period to achieve reliable results. The upper limit is determined by the time that is necessary to travel from the selected zero to the said given thickness. In the present case, a full period appears to be the optimized time and the etch rate ER1 is given by ER1 = (ER1(1) + ER1(2))/2 . Similar reasoning applies to the determination of ER2. In the practical experiment illustrated in conjunction with Fig. 5B, it has been found ER1= 140 nm/min and ER2 = 145 nm/min.

The selection tests can be performed in the same two half-period intervals between zero locations (4) and (3) on the one hand, and (3) and (2) on the other hand as mentioned above, in order to determine which pair primary signal is best adapted to the particular refractive index N of the product wafer being processed. For each signal pair, basically, two categories of test criteria have been adopted. The first one is related to the symmetry of the curves depicting the signal pair S/S' and the second one is related to the etch rate value ER. The comparison between signal pairs S1/S'1 and S2/S'2 for analysis in order to determine which one is to be selected is performed by computer 36 but it can be achieved a number of ways including the use of expert systems or neuron based processors. Let us now describe the implementation of the first category of criteria, which necessitates three symmetry related tests. For convenience, these tests will be described by reference to signal pair S1/S'1. These tests consist to measure: the amplitudes il and i2 at two successive extrema (they are directly related to signal intensity) of primary signal S1, the distances and the arch surfaces between two successive zeroes for the portion of the derivative signal S'1 between zeroes labelled (4) and (3) and between (3) and (2) respectively. The results are compared to determine whether they are identical or not. The more they are close, the better is the symmetry of signal pair S1/S'1. The second category of tests consists in conducting different etch rate measurements during the same period and check the value does not significantly changes with time. As soon as the computer 36 sees a significant change in the etch rate value, the corresponding signal pair, and thus the corresponding wavelength would be immediately dismissed. Similar selection tests and analysis are conducted on signal pair S2/S'2. Tolerated variations with regard to all these tests are inputted in the computer. Other categories of tests can be envisioned as well.

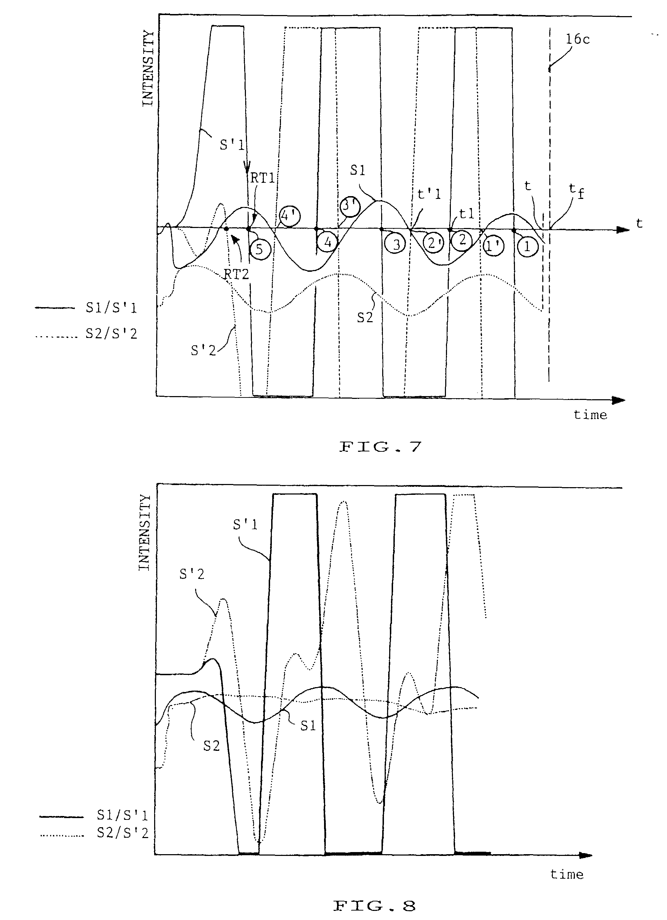

As a consequence, every time a result is not acceptable for a determined primary signal, the latter is dismissed by the computer. The best primary signal and thus the corresponding wavelength are selected according to box 68. The selection criterion discussed above cannot be made apparent from Fig. 5B, because the signals S1 and S2 have been illustrated with a quite ideal shape. This point will be better understood in conjunction with Figs. 7 and 8, which are real computer printouts taken during the monitoring of etching a product wafer according to the monitoring method of the present invention.

Figs. 7 and 8 illustrate the waveforms of signals that have been obtained during the etch process of some product wafer that are used by the computer 36 (and by operators servicing the RIE tool as well). Note that the nominal thickness of the product wafer that was used for these experiments is not equal to 650 nm.

Now turning to Fig. 7, there is shown curves that are illustrative of two primary signals S1 and S2 at time t at a few seconds before the etch process stops. As apparent from Fig. 7, signals S1 and S2 are perfectly adapted to optical properties of stack 12 and in particular to the refractive index N of the SiO2 layer 15 of the product wafer in consideration. Obviously, either primary signal S1 or S2 is adequate and thus either wavelength L1 or L2 may be selected. The selection tests are preferably terminated at time t1 (the latest of the two elapsed times t1 and t'1) for both signals S1 and S2 before taking its decision. On the contrary, Fig. 8 shows a primary signal S2 that is totally misadapted with said stack 12 and said refractive index N. In this case, wavelength L2 must be obviously dismissed. By the way, as apparent from the comparison between signals S1 and S2 of Fig. 8, as far as the first category of criteria (symmetry) mentioned above is concerned, it is clear that signal S2 not only lacks of a good periodicity, but has poor intensity. Signal S2 would also fail the etch rate test because of inadmissible variations in its value as a function of time.

Let us assume for the following, that signal S1 of Fig. 5B has been selected by the computer. The computer is now able to terminate the etch operation according to box 69.

The remaining time dt1 corresponds to the time necessary to travel from the last extremum of curve S1 corresponding to zero labelled (1) of curve S'1 to surface 16c (etch end point). It thus requires the knowledge of the etch rate value ER1 that has been previously calculated for the product wafer being etched. The remaining time dt1 is equal to D1/ER1, D1 being available from the STOP THICKNESS parameter ST1. Still using the above figures, D1 = 37 nm, thus dt1 = 37*60/140 = 16 sec. For signal S2, with D2 = 47 nm and ER2 = 145 nm, the corresponding remaining time value would have been given by dt2 = 19 sec. When this time has elapsed, the etch process is stopped as indicated by box 70. This means that surface 16c has been reached and the real thickness of the remaining SiO2 layer 15 is very close of the desired value Ef.

Although, the monitoring method of the present invention has been described in separating the preliminary steps of determining the etch end point criteria using a specimen wafer for sake of simplicity of the description, it should be understood that the specimen wafer may be a product wafer selected in the lot to be processed, provided that care is exercised not to etch too much, not to waste it as mentioned above.

If the technology is capable to produce the stack 12 without said optical characteristic dispersions or if a dedicated site is specifically used for that purpose, the use of one wavelength instead of two can be envisioned as mentioned above.

The monitoring method of the present invention has some definite advantages. First of all, the SiO2 layer 15 is etched down to a given thickness (and not to a given depth as practiced in the prior art) with great accuracy. In addition, the monitoring method of the present invention allows a significant reduction of the processing time because ex-situ measurements are no longer required, the number of processing steps is reduced and therefore the risk of human errors. The processing time is also optimized, it is equal to the time that is really necessary to reach the said given thickness. There is also a significant rework reduction as a result of the good reproducibility of the SiO2 remaining layer 15 thickness that is finally obtained. As a direct consequence, there is less contamination and manufacturing yields are improved. The use of at least two specified wavelengths combined with a large size light beam allows to get rid of optical characteristic dispersions in the stack 12. Finally, the etch rate measurement not only provide an accurate value in-situ and on-line for the product wafer being processed but also allows a direct control of any drift of the etching process parameters, providing thereby a valuable information for intelligent maintenance of the etching equipment 21.

## Claims

1. A reactor system (20) for etching a semiconductor wafer (24) having a dielectric film (15) formed onto a substrate (11, 13, 14) and automatically terminating said etching upon reaching a given thickness Ef of the said dielectric film whatever the errors on the nominal thickness E and refractive index N due to process variations; said reactor system comprising:
(a) an etch processing chamber (22) having a view-port (26) formed in one wall thereof in which the structure is received for etch treatment;
(b) light source means (29) generating a light containing at least two specified wavelength (L1, L2, ... ) whose value is greater than a minimum value (Lmin) equal to 4*N*e (wherein e is the thickness error);
(c) optical means (30, 31, 32) for transporting the light from said light source means to illuminate a large area of said wafer through said view port substantially at a normal angle of incidence through said view-port and for collecting the light reflected from the wafer;
(d) spectrometer means (33A, 33B, ... ) connected to said optical means, being tuned on a specified wavelength, for converting the reflected light into at least two corresponding analog interference signals (S1, S2, ... ) whose intensity varies with reaction time; and,
(e) signal processing/analyzing means (34) including:
means for digitalizing said analog interference signals to generate respective digital primary signals (S1, S2, ... );
means for starting the analysis of the primary signals after a predetermined time disregarding period or RATE TIME (RT1, RT2, ... ) the etching process has begun which defines a selected extremum for each primary signal;
means for counting a predetermined number (X1, X2, ... ) of extrema as from this selected extremum until the last extremum of each primary signal just before the given thickness Ef is attained;
means for determining the distances (D1, D2, ... ) between the last extremum of primary signals and said given thickness;
means for measuring the etch rates (ER1, ER2, ... ) in-situ and on-line for each primary signal;
means for analyzing the symmetry of waveforms of said primary signals and the etch rate variations to identify which one is the most adapted to the composition of the dielectric film and for selecting the corresponding signal/wavelength couple (e.g. S1/L1);
means for determining the remaining time (e.g. dt1 = D1/ER1) for the selected primary signal (e.g. S1); and,
means for terminating the etching treatment when said remaining time has elapsed.

2. The system of claim 1 or 2 wherein certain operations performed in the signal processing/analyzing means are conducted on the derivative signals (S'1, S'2, ... ) that are obtained from the primary signals by numeric filtering.

3. The system of claim 1 or 2 wherein said light source means consists of a multi-wavelength light source.

4. The system of claim 3 wherein said multi-wavelength light source is selected in the group of polychromatic light sources including mercury, halogen and xenon lamps.

5. The system of claim 3 wherein said multi-wavelength light source consists of a plurality of monochromatic lasers, each having a determined wavelength.

6. The system of claim 3 wherein said multi-wavelength light source consists of at least one polychromatic light source and at least one monochromatic laser.

7. The system of any above claim 1 to 6 wherein said optical means includes a projecting optical system which essentially consists of a condenser lens (31).

8. The system of any above claim wherein only one wavelength (L1) is used in combination with the illumination of a small area of the structure.

9. An apparatus (28) for monitoring the etching of a semiconductor wafer (24) placed in the processing chamber (22) provided with a view-port (26) of an etching equipment (21), said wafer having a dielectric film (15) formed onto a substrate (11, 13, 14) to automatically terminate said etching upon reaching a given thickness Ef of the said dielectric film whatever the errors on the nominal thickness E and refractive index N due to process variations; said apparatus comprising:
(a) light source means (29) generating a light containing at least two specified wavelengths (L1, L2, ... ) whose value is greater than a minimum value (Lmin) equal to 4*N*e (wherein e is the thickness error);
(b) optical means (30, 31, 32) for transporting the light from said light source means to illuminate a large area of said wafer substantially at a normal angle of incidence through said view-port and for collecting the light reflected from the wafer;
(c) spectrometer means (33A, 33B, ... ) connected to said optical means, being tuned on a specified wavelength, for converting the reflected light into at least two corresponding analog interference signals (S1, S2, ... ) whose intensity varies with reaction time; and,
(d) signal processing/analyzing means (34) including:
means for digitalizing said analog interference signals to generate respective digital primary signals (S1, S2, ... ) from said interference signals;
means for starting the analysis of the primary signals after a predetermined time disregarding period or RATE TIME (RT1, RT2, ... ) the etching process has begun which defines a selected extremum for each primary signal;
means for counting a predetermined number (X1, X2, ... ) of extrema as from this selected extremum until the last extremum of each primary signal just before the given thickness Ef is attained;
means for determining the distances (D1, D2, ... ) between the last extremum of primary signals and said given thickness;
means for measuring the etch rates (ER1, ER2, ... ) in-situ and on-line for each primary signal;
means for analyzing the symmetry of waveforms of said primary signals and the etch rate variations to identify which one is the most adapted to the composition of the dielectric film and for selecting the corresponding signal/wavelength couple (e.g. S1/L1);
means for determining the remaining time (e.g. dt1 = D1/ER1) for the selected primary signal (e.g. S1); and,
means for terminating the etching treatment when said remaining time has elapsed.

10. The apparatus of claim 9 wherein certain operations performed in the signal processing/analyzing means are conducted on the derivative signals (S'1, S'2, ... ) that are obtained from the primary signals by numeric filtering.

11. The apparatus of claim 9 or 10 wherein said light source means consists of a multi-wavelength light source.

12. The apparatus of any above claim 9 to 11 wherein said optical means includes a projecting optical system which essentially consists of a condenser lens (31).

13. The apparatus of any above claim 9 to 12 wherein only one wavelength (L1) is used in combination with the illumination of a small area of the structure.

14. A method of determining the etch end point criteria for the dry etching of a product wafer (24) consisting of a dielectric film (15) of nominal thickness E and refractive index N formed onto a substrate (11, 13, 14) at a given thickness Ef of the said dielectric film whatever the thickness error e and refractive index error n due to process variations; said method comprising the steps of:
(a) placing a specimen structure i.e. an ideal product wafer or a sample wafer having the said nominal thickness E in the processing chamber (22) provided with a view-port (26) of an etching equipment (21);
(b) illuminating a large area of the specimen wafer with a light containing at least two specified wavelength (L1, L2, ... ) whose value is greater than a minimum value (Lmin) equal to 4*N*e (wherein e is the thickness error on the product wafer given by the specification);
(c) applying the reflected light to spectrometer means (33A, 33B, ... ) being tuned on a specified wavelength for converting the reflected light into at least two corresponding analog interference signals (S1, S2, ... ) whose intensity varies with reaction time;
(d) digitalizing said analog interference signals to produce to produce respective digital primary signal (S1, S2, ... ); and,
(e) elaborating said etch end point criteria from the analysis of said primary signals which essentially consist of two parameters:
(1) the RATE TIME parameter (RT1, RT2, ... ) which takes into account both the initial time that is necessary to said primary signal to be reliable and the end time that is necessary to perform selection tests to determine which primary signal/wavelength couple is the most appropriate and etch rate measurements before said given thickness is attained; said rate time is correlated to a selected extremum of the primary signal; and;
(2) a STOP THICKNESS parameter (ST) comprised of three data (A X D): a first data (A) related to the manner the primary signal reaches an extremum; a second data (X) related to the number of extrema between said selected extremum and the last extremum before said given thickness is attained and a third data (D) giving the distance between said last extremum and said given thickness.

15. The method of claim 14 wherein certain operations performed on the primary signals are in fact performed on the derivative signal (S'1, S'2, ... ) that are respectively derived therefrom by numeric filtering.

16. The method of claim 14 or 15 wherein only one wavelength (L1) is used in combination with the illumination of a small area of the structure.

17. A method of monitoring the dry etching of a product semiconductor wafer (24) having a dielectric film (15) of nominal thickness E and refractive index N formed onto a substrate (11, 13, 14) at a given thickness Ef of the said dielectric film whatever the thickness error e and refractive error n due to process variations; said method comprising the steps of:
(a) elaborating the etch end point criteria as described by reference to any of above claim 14 to 16 for a specimen wafer having the same characteristics as the product wafer so that the RATE TIME (RT) and STOP THICKNESS ST (ST = A X D) are determined;
(b) placing the product wafer in the etch processing chamber (22) provided with a view-port (26) of an etching equipment (21);
(c) illuminating the wafer with a light containing at least two specified wavelengths (L1, L2, ... ) whose value is greater than a minimum value (Lmin) equal to 4*N*e;
(d) applying the reflected light to spectrometer means being tuned on a specified wavelength to generate corresponding analog interference signals (S1, S2, ... ) whose intensity varies with the reaction time;
(e) digitalizing said analog interference signals to produce respective digital primary signals (S1, S2, ... );
(f) as soon as the RATE TIME has elapsed at the selected extremum, counting the predetermined number (X1, X2, ... ) of extrema of each primary signal as from the selected extremum until the last extremum just before the given thickness is attained;
(g) in the meantime, measuring the etch rate (ER1, ER2, ... ) in-situ and on-line for each primary signal and analyzing the symmetry of waveforms of primary signals and the etch rate variations to identify which primary signal/wavelength couple (e.g. S1/L1) is the most adapted to the composition of the dielectric film;
(h) determining the remaining time (dt1 = D1/ER1) for the selected couple before reaching etch end point before the earliest of said last extrema is reached; and,
(i) terminating the etching treatment when said remaining time has elapsed.

## Patentansprüche

1. Ein Reaktorsystem (20) zum Ätzen eines Halbleiterwafer (24) mit einem dielektrischen Film (15), der auf einem Substrat (11, 13, 14) ausgebildet ist, und automatisches Beenden dieses Ätzvorgangs bei Erreichen einer gegebenen Dicke Ef des dielektrischen Films, unabhängig von den Fehlern und der Nenndicke E und der Brechungszahl N infolge von Verfahrensvariationen, wobei das Reaktorsystem beinhaltet:
(a) eine Ätzbearbeitungskammer (22) mit einer in einer Seitenwand ausgebildeten Sichtöffnung (26), in der die Struktur zur Ätzbehandlung aufgenommen wird;
(b) Lichtquellenmittel (29), die ein Licht generieren, das mindestens zwei spezifizierte Wellenlängen (L1, L2, ... ) enthält, deren Wert größer ist als ein mindestwert (Lmin) gleich 4*N*e (wobei e der Dickenfehler ist);
(c) optische Mittel (30, 31, 32) zum Leiten des Lichts von den Lichtquellenmitteln zum Beleuchten eines großen Bereichs des Wafers durch die Sichtöffnung im wesentlichen unter einem normalen Einfallswinkel durch die Sichtöffnung und zum Sammeln des Lichts, das vom Wafer reflektiert wird;
(d) Spektrometermittel (33A, 33B, ... ), die an die optischen Mittel angeschlossen sind, die auf eine spezifizierte Wellenlänge eingestellt sind, um das reflektierte Licht in mindestens zwei entsprechende analoge Interferenzsignale (S1, S2, ... ) umzuwandeln, deren Intensität sich mit der Reaktionszeit verändert; und
(e) Signalverarbeitungs/Analysierungsmittel (34), einschließlich:
Mittel zum Digitalisieren der Analog-Interferenzsignale zum Generieren entsprechender digitaler Primärsignale (S1, S2 ... );
Mittel zum Anlaufenlassen der Analyse der Primärsignale nach einer vorgegebenen Zeit, unter Außerachtlassung der Periode oder Vorhaltezeit (RATE TIME - RT1, RT2, ... ), mit der der Ätzprozeß begonnen hat, die einen ausgewählten Extremwert für jedes Primärsignal definiert;
Mittel zum Zählen einer vorgegebenen Anzahl (X1, X2, ...) Extremwerten, wie von dem gewählten Extremwert bis zum letzten Extremwert jedes Primärsignals kurz vor Erreichen der gegebene Dicke Ef;
Mittel zum Bestimmen der Abstände (D1, D2, ...) zwischen dem letzten Extremwert der Primärsignale und der gegebenen Dicke;
Mittel zum Messen der Ätzraten (ER1, ER2, ...) in situ und on-line für jedes Primärsignal;
Mittel zum Analysieren der Symmetrie der Wellenformen der Primärsignale und der Ätzratenveränderungen zum Identifizieren, welches das am besten an die Zusammensetzung des dielektrischen Films angepaßte Signal ist, und zum Auswählen des entsprechenden Signal/Wellenlängen-Paars (z.B. S1/L1);
Mittel zum Bestimmen der Restzeit (z.B. dt1 = D1/ER1) für das gewählte Primärsignal (z.B. S1); und
Mittel zum Beenden des Ätzbehandlung, sobald diese Restzeit abgelaufen ist.

2. Das System gemäß Anspruch 1 oder 2, in dem bestimmte Operationen im Signalverarbeitungs/Analysemittel mit den Ableitungssignalen (S'1, S'2, ...) ausgeführt werden, die aus den Primärsignalen durch numerisches Filtern erhalten werden.

3. Das System gemäß Anspruch 1 und 2, in dem das Lichtquellen-Mittel aus einer Mehrfachwellenlängen-Lichtquelle besteht.

4. Das System gemäß Anspruch 3, in dem die Vielfach-Wellenlängen-Lichtquelle aus der Gruppe der polychromatischen Lichtquellen einschließlich Quecksilber-, Halogen- und Xenonlampen gewählt wird.

5. Das System gemäß Anspruch 3, in dem die Vielfach-Wellenlängen-Lichtquelle aus einer Vielzahl monochromatischer Laser besteht, deren jeder eine bestimmte Wellenlänge aufweist.

6. Das System gemäß Anspruch 3, in dem die Vielfach-Wellenlängen-Lichtquelle aus mindestens einer polychromatischen Lichtquelle und mindestens einem monochromatisichen Laser besteht.

7. Das System aus einem beliebigen der obigen Ansprüche 1 bis 6, in dem das optische Mittel ein optisches Projektionssystem beinhaltet, das im wesentlichen aus einer Kondensatorlinse (31) besteht.

8. Das System aus einem beliebigen obigen Anspruch, bei dem nur eine einzige Wellenlänge (L1) benutzt wird in kombination mit der Beleuchtung eines kleinen Bereichs der Struktur.

9. Ein Gerät zur Überwachung des Ätzens eines HalbleiterWafers (24), der in eine Bearbeitungskammer (22) eines Atzgeräts (21) mit einer Sichtöffnung (26) gelegt wird, wobei der Wafer mit einem dielektrischen Film (15) versehen ist, der auf einem Substrat (11, 13, 14) ausgebildet ist, um das Ätzen bei Erreichen einer gegebenen Dicke Ef des dielektrischen Films automatisch zu beenden ungeachtet der Fehler der Nenndicke e und des Brechungsindex N infolge Prozeßvariationen zu beenden; wobei dieses Gerät umfaßt:
(a) Lichtquellenmittel (29), die ein Licht generieren, das mindestens zwei spezifizierte Wellenlängen (L1, L2, ...) enthält, deren Wert größer ist als ein Mindestwert (Lmin) gleich 4*N*e (wobei e der Dickenfehler ist);
(b) optische Mittel (30, 31, 32) zum Leiten des Lichts von den Lichtquellenmitteln zum Erleuchten eines großen Bereichs des Wafers durch die Sichtöffnung im wesentlichen unter einem normalen Einfallswinkel durch die Sichtöffnung und zum Sammeln des Lichts, das vom Wafer reflektiert wird;
(c) Spektrometermittel (33A, 33B, ... ), die mit den optischen Mittel verbunden sind, die auf eine spezifische Wellenlänge eingestellt sind, um das reflektierte Licht in mindestens zwei entsprechende analoge Interferenzsignale (S1, S2, ... ) umzuwandeln, deren Intensität sich mit der Reaktionszeit verändert; und
(d) Signalbearbeitungs/Analysierungsmittel (34), einschließlich:
Mittel zum Digitalisieren der Analog-Interferenzsignale zum Generieren entsprechender digitaler Primärsignale (S1, S2 ... ) aus den Interferenzsignalen;
Mittel zum Anlaufenlassen der Analyse der Primärsignale nach vorgegebener Zeit, unter Außerachtlassung der Periode oder Vorhaltezeit (RATE TIME - RT1, RT2, ... ), mit der der Ätzprozeß begonnen hat, der einen ausgewählten Extremwert für jedes Primärsignal definiert;
Mittel zum Zählen einer vorgegebenen Anzahl (X1, X2, ...) Extremwerte, wie von dem gewählten Extremwert bis zum letzten Extremwert jedes Primärsignals kurz bevor die gegebene Dicke Ef erreicht ist;
Mittel zum Bestimmen der Abstände (D1, D2, ...) zwischen dem letzten Extremwert der Primärsignale und der gegebenen Dicke;
Mittel zum Messen der Ätzraten (ER1, ER2, ...) in situ und on-line für jedes Primärsignal;
Mittel zum Analysieren der Symmetrie der Wellenform der Primärsignale und der Ätzratenveränderungen zum Identifizieren, welche am besten an die Zusammensetzung des dielektrischen films angepaßt ist, und zum Auswählen des entsprechenden Signal/Wellenlängen-Paars (z.B. S1/L1);
Mittel zum Bestimmen der Restzeit (z.B. dt1 = D1/ER1) für das gewählte Primärsignal (z.B. S1); und
Mittel zum Beenden des Ätzbehandlung, sobald diese Restzeit abgelaufen ist.

10. Das Gerät gemäß Anspruch 9, in dem bestimmte Operationen im Signalverarbeitungs/Analysemittel mit den Ableitungssignalen (S'1, S'2, ...) ausgeführt werden, die aus den Primärsignalen durch numerisches Filtern erhalten werden.

11. Das Gerät gemäß Anspruch 9 oder 10, in dem das Lichtquellen-Mittel aus einer Mehrfachwellenlängen-Lichtquelle besteht.

12. Das Gerät gemäß einem beliebigen der obigen Ansprüche 9 bis 11, in dem das optische Mittel ein optisches Projektionssystem beinhaltet, das im wesentlichen aus einer Kondensatorlinse (31) besteht.

13. Das Gerät eines beliebigen der obigen Ansprüche 9 bis 12, bei dem nur eine einzige Wellenlänge (L1) benutzt wird in Kombination mit der Beleuchtung eines kleinen Bereichs der Struktur.

14. Ein Verfahren zur Bestimmung des Ätzendpunktkriteriums für das Trockenätzen eines Wafers (24), bestehend aus einem dielektrischen Film (15) einer Nenndicke E und eines Brechungsindex N, der auf einem Substrat (11, 13, 14) mit einer gegebenen Dicke Ef des dielektrischen Films ausgebildet ist, unabhängig von dem Dickenfehler e und dem Fehler n der Brechungszahl infolge von Verfahrensvariationen, wobei das Verfahren die folgenden Schritte beinhaltet:
(a) Legen einer Probestruktur, d.i. ein ideales Wafer-produkt oder einen Musterwafer, mit der Nenndicke E in die mit einer Sichtöffnung (26) versehene Bearbeitungskammer (22) eines Atzgeräts (21);
(b) Belichten eines großen Bereichs des Probewafers mit einem Licht, das mindestens zwei spezifizierte Wellenlängen (L1, L2, ...) aufweist, deren Wert größer als ein Mindestwert (Lmin) gleich 4*N*e ist (wobei e der Dickenfehler des Produktwafers ist, der durch die Spezifikation gegeben ist);
(c) Anlegen des reflektierten Lichts an Spektrometermittel (33A, 33B, ... ), die auf eine spezifizierte Wellenlänge eingeregelt sind, um das reflektierte Licht in mindestens zwei entsprechende analoge Interferenzsignale (S1, S2, ... ) umzuwandeln, deren Intensität sich mit der Reaktionszeit verändert;
(d) Digitalisieren der Analog-Interferenzsignale zum Erzeugen entsprechender digitaler Primärsignale (S1, S2 ... ); und
(e) Erarbeiten der Atzendpunkt-Kriterien aus der Analyse der Primärsignale, die im wesentlichen aus zwei Parametern bestehen:
(1) dem RATE TIME Parameter (RT1, RT2, ...), der sowohl die Anfangszeit, die für das Primärsignal erforderlich ist, damit es zuverlässig ist, als auch die Endzeit, die zur Durchführung der Auswahl tests erforderlich ist, um festzulegen, welches Primärsignal/Wellenlängen-Paar am besten geeignet ist, und die Ätzratenmessungen bevor die gegebene Dicke erreicht ist, berücksichtigt; wobei die Rate Time zu einem ausgewählten Extremwert des Primärsignals in Korrelation steht; und
(2) ein STOP THICKNESS Parameter (ST), bestehend aus drei Daten (A X D) : Einem ersten Datum (A), das mit der Art und Weise in Beziehung steht, mit der das Primärsignal einen Extremwert erreicht; einem zweiten Datum (X), das mit der Anzahl der Extremwerte zwischen dem gewählten Extremwert und dem letzen Extremwert vor Erreichen der gegebenen Dicke in Beziehung steht, und einem dritten Datum (D), das den Abstand zwischen dem letzen Extremwert und der gegebenen Dicke angibt.

15. Das Verfahren gemäß Anspruch 14, in dem bestimmte Operationen an den Primärsignalen de facto an den Ableitungssignalen (S'1, S'2, ...) ausgeführt werden, die von diesen durch numerisches Filtern abgeleitet werden.

16. Das Verfahren gemäß Anspruch 14 oder 15, bei dem nur eine einzige Wellenlänge (L1) benutzt wird in Kombination mit der Belichtung eines kleinen Bereichs der Struktur.

17. Ein Verfahren zur Überwachung des Trockenätzens eines Produkt-Halbleiter-Wafers (24), der einen dielektrischen Film (15) einer Nenndicke E und einen Brechungsindex N aufweist, auf einem Substrat (11, 13, 14) mit einer gegebenen Dicke Ef des dielektrischen Films ausgebildet ist, unabhängig vorn Dickenfehler e und vom Brechungsindexfehler n infolge Prozeßvariationen; wobei dieses Verfahrten die folgenden Schritte umfaßt:
(a) Ausarbeiten der Atzendpunktkriterien, wie oben unter Bezugnahme auf einen beliebigen der obigen Ansprüche 14 bis 16 beschrieben, für einen Probewafer, der die gleichen Merkmale aufweist wie der Produktwafer, so daß die RATE TIME (RT) und die STOP THICKNESS ST (ST = A X D) bestimmt werden;
(b) Verbringen des Produktwafer in die Ätzbearbeitungskammer (22) eines Ätzgeräts (21) mit einer Sichtöffnung (26);
(c) Belichten des Wafer mit einem Licht, das mindestens zwei spezifizierte Wellenlängen (L1, L2 ...) umfaßt, deren Wert größer ist ein Minimumwert (Lmin) gleich 4*N*e;
(d) Legen des reflektierten Lichts an Spektrometemittel, die so auf eine spezifizierte Wellenlänge eingeregelt sind, daß sie entsprechende analoge Interferenzsignale (S1, S2, ...) generieren, deren Intensität mit der Reaktionszeit variiert;
(e) Digitalisieren der analogen Interferenzsignale, um entsprechende digitale Primärsignale (S1, S2, ...) zu produzieren;
(f) sobald die RATE TIME am ausgewählten Extremwert verstrichen ist, Zählen der vorbestimmten Anzahl (X1, X2, ...) Extremwerte jedes Primärsignals vom gewählten Extremwert bis zum letzten Extremwert eben bevor die gegebene Dicke erreicht ist;
(g) inzwischen Messen der Ätzrate (ER1, ER2, ...) in situ und on-line für jedes Primärsignal und Analysieren der Symmetrie der Wellenformen der Primärsignale und der Ätzratenveränderungen, zur Identifizierung, welches Primärsignal/Wellenlängen-Paar (z.B. S1/L1) der Zusammensetzung des dielektrischen Films am besten angepaßte;
(h) Bestimmen der Restzeit (dt1 = D1/ER1) für das ausgewählte Paar vor Erreichen des Ätzendpunkts, bevor der früheste der letzen Extremwerte erreicht ist; und
(i) Beenden der Ätzbehandlung wenn die Restzeit abgelaufen ist.

## Revendications

1. Un système à réacteur (20), pour graver une tranche à semi-conducteur (24) ayant un film diélectrique (15) formé sur un substrat (11, 13, 14), et à achèvement automatique de ladite gravure lors de l'atteinte d'une épaisseur donnée Ef dudit film diélectrique, quelles que soient les erreurs concernant l'épaisseur nominale E et l'indice de réfraction N, imputables aux fluctuations du processus; ledit système à réacteur comprenant :
(a) une chambre de traitement de gravure (22) ayant un orifice d'observation (26) formé sur une paroi de celle-ci, dans laquelle la structure est logée pour le traitement de gravure;
(b) des moyens de source lumineuse générant une lumière contenant au moins deux longueurs d'ondes spécifiées (L1, L2,...), dont la valeur est supérieure à une valeur minimale (Lmin) égale à 4*N*e (e étant l'erreur d'épaisseur);
(c) des moyens optiques (30, 31, 32) pour transporter la lumière desdits moyens de source lumineuse pour illuminer une large aire de ladite tranche, en passant à travers ledit orifice d'observation, sensiblement sous un angle d'incidence perpendiculaire à travers ledit orifice et pour collecter la lumière réfléchie depuis la tranche;
(d) des moyens spectrométriques (33A, 33B,...) reliés auxdits moyens optiques, accordés sur une longueur d'onde spécifiée pour convertir la lumière réfléchie en au moins deux signaux d'interférence analogiques (S1, S2, ...) correspondants, dont l'intensité varie avec le temps de réaction; et
(e) des moyens de traitement/analyse de signaux (34), comprenant :
des moyens pour numériser lesdits signaux d'interférence analogiques, pour générer des signaux primaires, numériques (S1, S2, ...);
des moyens pour démarrer l'analyse desdits signaux primaires après écoulement d'une période d'ignorance temporelle prédéterminée ou "TEMPS DE MISE EN CADENCEMENT" (RATE TIME - RT1, RT2, ...) auquel le processus de gravure a commencé, définissant un extrême sélectionné pour chaque signal primaire;
des moyens pour compter un nombre prédéterminé (X1, X2, ... ) d'extrêmes en partant de cet extrême sélectionné jusqu'au dernier extrême de chaque signal primaire juste avant atteinte de l'épaisseur Ef donnée,
des moyens pour déterminer les distances (D1, D2, ...) entre le dernier extrême des signaux primaires et ladite épaisseur donnée;
des moyens pour mesurer les vitesses de gravure (ER1, ER2, ...) in situ et en ligne pour chaque signal primaire;
des moyens pour analyser la symétrie des formes d'ondes desdits signaux primaires et les variations de vitesse de gravure, afin d'identifier ce qui est le plus adapté à la composition du film diélectrique et pour sélectionner le couple signal/longueur d'onde correspondant (par exemple, S1/L1);
des moyens pour déterminer le temps restant (par exemple, dt1 = D1/ER1) pour le signal primaire sélectionné (par exemple, S1); et
des moyens pour achever le traitement de gravure lorsque ledit temps restant s'est écoulé.

2. Le système selon la revendication 1 ou 2, dans lequel certaines opérations effectuées dans les moyens de traitement/analyse de signaux sont conduites sur les signaux dérivés (S'1, S'2... ) obtenus à partir des signaux primaires, par un filtrage numérique.

3. Le système selon la revendication 1 ou 2, dans lequel lesdits moyens de source lumineuse sont constitués d'une source lumineuse à longueurs d'ondes multiples.

4. Le système selon la revendication 3, dans lequel ladite source lumineuse à longueurs d'ondes multiples est sélectionnée dans le groupe des sources lumineuses polychromatiques, y compris les lampes au mercure, halogène et xénon.

5. Le système selon la revendication 3, dans lequel ladite source lumineuse à longueurs d'ondes multiples est constituée d'une pluralité de lasers monochromatiques, ayant chacun une longueur d'onde déterminée.

6. Le système selon la revendication 3, dans lequel ladite source lumineuse à longueurs d'ondes multiples est constituée d'au moins une source lumineuse polychromatique et d'au moins un laser monochromatique.

7. Le système selon l'une quelconque des revendications 1 à 6, dans lequel lesdits moyens optiques comprennent un système optique de projection constitué essentiellement d'une lentille de condensation (31).

8. Le système selon l'une quelconque des revendications ci-dessus, dans lequel seule une longueur d'onde (L1) est utilisée en combinaison avec l'illumination d'une petite aire de la structure.

9. Un dispositif (28), pour surveiller la gravure d'une tranche à semi-conducteur (14), placée dans la chambre de traitement (22), dotée d'un orifice d'observation (26), d'un équipement de gravure (21), ladite tranche ayant un film diélectrique (15) formé sur un substrat (11, 13, 14), afin d'achever automatiquement la gravure lors de l'atteinte d'une épaisseur Ef donnée dudit film diélectrique, quelles que soient les erreurs sur l'épaisseur nominale E et l'indice de réfraction N, imputables à des fluctuations du processus; ledit dispositif comprenant :
(a) des moyens de source lumineuse (29) générant une lumière contenant au moins deux longueurs d'ondes (L1, L2... ) spécifiées, dont la valeur est supérieure une valeur minimale (Lmin) égale à 4*N*e (dans laquelle e est l'erreur d'épaisseur);
(b) des moyens optiques (30, 31, 32) pour transporter la lumière depuis lesdits moyens de source lumineuse, afin d'illuminer une grande aire de ladite tranche, sensiblement sous un angle d'incidence perpendiculaire, en passant à travers ledit orifice d'observation et pour collecter la lumière réfléchie de la tranche;
(c) des moyens spectrométriques (33A, 33B,...) connectés auxdits moyens optiques, accordés sur une longueur d'onde spécifiée, pour convertir la lumière réfléchie en au moins deux signaux d'interférence analogiques (S1, S2, ...) correspondants, dont l'intensité varie en fonction du temps de réaction; et
(d) des moyens de traitement/analyse de signaux (34), comprenant :
des moyens pour numériser lesdits signaux d'interférence analogiques, en vue de générer des signaux primaires, numériques (S1, S2, ...) à partir desdits signaux d'interférence;
des moyens pour démarrer l'analyse desdits signaux primaires après écoulement d'une période de temps d'ignorance prédéterminée ou "TEMPS DE MISE EN CADENCEMENT" (RATE TIME - RT1, RT2, ...), le processus de gravure ayant commencé, définissant un extrême sélectionné pour chaque signal primaire;
des moyens pour compter un nombre prédéterminé (X1, X2, ...) d'extrêmes, depuis cet extrême sélectionné jusqu'au dernier extrême de chaque signal primaire, juste avant atteinte de l'épaisseur Ef donnée;
des moyens pour déterminer les distances (D1, D2, ...) entre le dernier extrême des signaux primaires et ladite épaisseur donnée;
des moyens pour mesurer les vitesses de gravure (ER1, ER2, ...) in situ et en ligne pour chaque signal primaire;
des moyens pour analyser la symétrie des formes d'ondes desdits signaux primaires et les variations de vitesse de gravure, afin d'identifier ce qui est le plus adapté à la composition du film diélectrique et pour sélectionner le couple signal/longueur d'onde correspondant (par exemple S1/L1);
des moyens pour déterminer le temps restant (par exemple, dt1 = D1/ER1) pour le signal primaire sélectionné (par exemple, S1); et
des moyens pour achever le traitement de gravure lorsque ledit temps restant s'est écoulé.

10. Le dispositif selon la revendication 9, dans lequel certaines opérations effectuées dans les moyens de traitement/analyse de signal, sont conduites sur les signaux dérivés (S'1, S'2...) obtenus à partir des signaux primaires, par filtrage numérique.

11. L'appareil selon la revendication 9 ou 10, dans lequel lesdits moyens de source lumineuse sont constitués d'une source lumineuse à longueurs d'ondes multiples.

12. L'appareil selon l'une quelconque des revendications 9 à 11, dans lequel lesdits moyens optiques comprennent un système optique de projection, constitué essentiellement d'une lentille de condensation (31).

13. Le dispositif selon l'une quelconque des revendications 9 à 12, dans lequel seule une longueur d'onde (L1) est utilisée en combinaison avec l'illumination d'une petite aire de la structure.

14. Un procédé de détermination des critères de point final de gravure, pour la gravure sèche d'une tranche de produit (24) constituée d'un film électrique (15), d'une épaisseur nominale E et d'un indice de réfraction nominal N, formé sur un substrat (11, 13, 14) à une épaisseur Ef donnée du film diélectrique, quelles que soient l'erreur de détection e et l'erreur d'indice de réfraction n imputables au processus; ledit procédé comprenant les étapes consistant à :
(a) placer une structure échantillon, c'est-à-dire une tranche de produit idéale ou une tranche d'échantillon ayant ladite épaisseur nominale E, dans la chambre de traitement (22) dotée d'un orifice d'observation (26) d'un équipement de gravure (21);
(b) illuminer une grande aire de la tranche d'échantillon avec une lumière contenant au moins deux longueurs d'ondes spécifiées (L1, L2, ...) dont la valeur est supérieure à une valeur minimale (Lmin) égale à 4*N*e (dans laquelle e est l'erreur d'épaisseur sur la tranche de produit, donnée par la spécification);
(c) appliquer la lumière réfléchie à des moyens spectrométriques (33A, 33B, ...) accordés sur une longueur d'onde spécifiée pour convertir la lumière réfléchie en au moins deux signaux d'interférence analogiques correspondants (S1, S2, ...), dont l'intensité varie avec le temps de réaction;
(d) numériser lesdits signaux d'interférence analogiques pour générer un signal primaire, numérique (S1, S2, ...) respectif; et
(e) élaborer lesdits critères de point final de gravure à partir de l'analyse desdits signaux primaires, qui sont essentiellement constitués de deux paramètres :
(1) le paramètre TEMPS DE MISE EN CADENCEMENT (RATE TIME - RT1, RT2, ...) qui prend en compte à la fois le temps initial nécessaire audit signal primaire pour devenir fiable et le temps final qui est nécessaire pour effectuer les tests de sélection pour déterminer quel couple signal primaire/longueur d'onde est le plus approprié et effectuer les mesures de vitesse de gravure avant atteinte de ladite épaisseur donnée; ledit temps de mise en cadencement étant en corrélation avec un extrême sélectionné du signal primaire; et
(2) un paramètre EPAISSEUR D'ARRET (STOP THICKNESS - ST), constitué de trois données (A X D) : des premières données (A) liées à la manière selon laquelle un signal primaire atteint un extrême, des deuxièmes données (X) liées au nombre d'extrêmes existant entre ledit extrême sélectionné et le dernier extrême avant atteinte de ladite épaisseur donnée, et des troisièmes données (D) donnant la distance entre ledit dernier extrême et ladite épaisseur donnée.

15. Le procédé selon la revendication 14, dans lequel certaines opérations effectuées sur les signaux primaires sont en fait effectuées sur les signaux dérivés (S'1, S'2, ...) qui sont respectivement dérivés de ceux-ci par un filtrage numérique.

16. Le procédé selon la revendication 14 ou 15, dans lequel une seule longueur d'onde (L1) est utilisée en combinaison avec l'illumination d'une petite aire de la structure.

17. Un procédé de surveillance de la gravure sèche d'une tranche à semi-conducteur (24) constituant un produit, ayant un film diélectrique (15) d'épaisseur nominale E et un indice de réfraction N, formé sur un substrat (11, 13, 14) à une épaisseur Ef donnée dudit film diélectrique, quelles que soient l'erreur d'épaisseur e et l'erreur d'indice de réfraction n, imputables aux fluctuations du processus; ledit procédé comprenant les étapes consistant à :
(a) élaborer dits critères de point final de gravure, tel que décrits en référence à l'une quelconque des revendications 14 à 16, pour une tranche échantillon ayant les mêmes caractéristiques que la tranche de produit, si bien que le TEMPS DE MISE EN CADENCEMENT (RT) et L'EPAISSEUR D'ARRET ST (ST = A X D) soient déterminés;
(b) placer la tranche de produit dans la chambre de traitement de gravure, équipée d'un orifice d'observation (26), d'un équipement de gravure (21);
(c) illuminer la tranche avec une lumière contenant au moins deux longueurs d'ondes spécifiées (L1, L2, ...), dont la valeur est supérieure à une valeur minimale (Lmin) égale à 4*N*e;
(d) appliquer la lumière réfléchie à des moyens spectrométriques (33A, 33B, ...) accordés sur une longueur d'onde spécifiée, pour générer des signaux d'interférence analogiques (S1, S2, ...) correspondants, dont l'intensité varie avec le temps de réaction;
(e) numériser lesdits signaux d'interférence analogiques pour produire des signaux primaires, numériques (S1, S2, ...) respectifs;
(f) dès que le TEMPS DE MISE EN CADENCEMENT s'est écoulé, à l'extrême sélectionné, compter le nombre prédéterminé (X1, X2, ...) d'extrêmes de chaque signal primaire, depuis l'extrême sélectionné jusqu'à atteinte du dernier extrême juste avant l'épaisseur donnée;
(g) dans l'intervalle, mesurer la vitesse de gravure (ER1, ER2, ...) in situ et en ligne pour chaque signal primaire et analyser la symétrie des formes d'ondes desdits signaux primaires et les variations de vitesse de gravure, pour identifier quel couple de signal primaire/longueur d'onde (par exemple, S1/L1); est le plus adapté à la composition du film diélectrique;
(h) déterminer le temps restant (dt1 = D1/ER1) pour le couple sélectionné avant atteinte du point final de gravure, avant atteinte du plus précoce desdits derniers extrêmes; et
(i) achever le traitement de gravure lorsque ledit temps restant s'est écoulé.
